# EUROPEAN PATENT APPLICATION

(11) **EP 4 535 337 A1**
(43) Date of publication of application: **09.04.2025**
(21) Application number: 22944308.0
(22) Date of filing: 02.06.2022
(51) Int. Cl.: G09F 9/30, H05K 1/18

(54) **WIRING SUBSTRATE AND MANUFACTURING METHOD THEREFOR, LIGHT-EMITTING SUBSTRATE, AND DISPLAY APPARATUS**

(71) Applicant: Boe Technology Group Co., Ltd., Beijing 100015 (CN); Hefei Boe Ruisheng Technology Co., Ltd., Hefei, Anhui 230012 (CN)
(72) Inventor: WANG, Jie, Beijing 100176 (CN); JIN, Zhi, Beijing 100176 (CN); WU, Xintao, Beijing 100176 (CN); XU, Zouming, Beijing 100176 (CN); LIU, Huan, Beijing 100176 (CN); DING, Leiming, Beijing 100176 (CN); HAN, Tingwei, Beijing 100176 (CN); LUO, Ningyu, Beijing 100176 (CN)
(74) Representative: Studio Torta S.p.A.
(86) International application number: PCT/CN2022/096785
(87) International publication number: WO 2023/230977

(57) **Abstract**

The present disclosure provides a wiring substrate and a manufacturing method thereof, a light-emitting substrate, and a display device. The wiring substrate includes: a base substrate, including a functional region and a bonding region; a first conductive layer on the base substrate and at least in the functional region; a second conductive layer on the first conductive layer and at least in the functional region, the second conductive layer being electrically connected to the first conductive layer; a first insulating layer on a side of the second conductive layer away from the base substrate and including a main part and an opening. At least one of the first conductive layer and the second conductive layer includes a plurality of electrodes in the bonding region and extending along a first direction, each of the plurality of electrodes includes a first end adjacent to the functional region in the first direction, an orthographic projection of the main part of the first insulating layer on the base substrate at least partially overlaps with an orthographic projection of the first end of each electrode on the base substrate.

## Description

### TECHNICAL FIELD

The present disclosure relates to the field of display technology, and in particular to a wiring substrate, a light-emitting substrate and a display device comprising the wiring substrate, and a method for manufacturing the wiring substrate.

### BACKGROUND

Display devices generally comprise liquid crystal display devices and organic light-emitting diode display devices. Liquid crystal display devices are widely used due to their advantages such as thinness, lightness, good shock resistance, wide viewing angle, and high contrast. A liquid crystal display device generally comprises a display panel and a backlight, and the backlight is usually arranged on a non-display side of the display panel to provide a light source for the display of the display panel. Characteristics such as contrast, brightness uniformity and stability of the liquid crystal display device are related to the structure and performance of the backlight. In recent years, sub-millimeter light-emitting diodes (Mini-LEDs) have attracted widespread attention due to their excellent performance, and have been increasingly used in the backlight.

### SUMMARY

According to an aspect of the present disclosure, there is provided a wiring substrate. The wiring substrate comprises a base substrate comprising a functional region and a bonding region; a first conductive layer on the base substrate and at least in the functional region; a second conductive layer on a side of the first conductive layer away from the base substrate and at least in the functional region, the second conductive layer being electrically connected to the first conductive layer; and a first insulating layer on a side of the second conductive layer away from the base substrate and comprising a main part and an opening. At least one of the first conductive layer and the second conductive layer comprises a plurality of electrodes in the bonding region and extending along a first direction, each of the plurality of electrodes comprises a first end adjacent to the functional region in the first direction, and an orthographic projection of the main part of the first insulating layer on the base substrate at least partially overlaps with an orthographic projection of the first end of each electrode on the base substrate.

In some embodiments, the wiring substrate further comprises a second insulating layer between the first conductive layer and the second conductive layer, wherein the second conductive layer is in contact with the first conductive layer through a via in the second insulating layer.

In some embodiments, the second conductive layer comprises a first part and a second part, the first part is in the functional region, the second part is in the bonding region, the second part comprises a plurality of first electrodes extending along the first direction, and each of the plurality of first electrodes comprises the first end.

In some embodiments, the second conductive layer comprises a first surface facing away from the base substrate, a distance between a portion of the first surface at the first part and the base substrate is greater than a distance between a portion of the first surface at the second part and the base substrate, and an orthographic projection of the opening of the first insulating layer on the base substrate at least partially overlaps with an orthographic projection of the second part on the base substrate.

In some embodiments, the opening of the first insulating layer exposes a remaining portion of each first electrode except the first end.

In some embodiments, in the bonding region, the orthographic projection of the opening of the first insulating layer on the base substrate does not overlap with an orthographic projection of the second insulating layer on the base substrate.

In some embodiments, the first conductive layer is only in the functional region, and an orthographic projection of the first conductive layer on the base substrate partially overlaps with an orthographic projection of the first part of the second conductive layer on the base substrate.

In some embodiments, in the functional region, the first conductive layer comprises a second surface facing the second conductive layer and a side surface contiguous with the second surface and facing the bonding region, the second conductive layer is in direct contact with the side surface of the first conductive layer.

In some embodiments, the first conductive layer comprises a third part in the bonding region, the third part comprises a plurality of second electrodes extending along the first direction, the plurality of first electrodes correspond to the plurality of second electrodes one by one, and an orthographic projection of each of the plurality of first electrodes on the base substrate at least partially overlaps with an orthographic projection of a corresponding one of the plurality of second electrodes on the base substrate. Each first electrode is electrically connected to a second electrode corresponding to the first electrode, the first electrode and the second electrode which are electrically connected constitute the electrode, and both the first electrode and the second electrode which are electrically connected comprise the first end.

In some embodiments, orthographic projections of the first ends of the first electrode and the second electrode on the base substrate fall within the orthographic projection of the main part of the first insulating layer on the base substrate.

In some embodiments, the opening of the first insulating layer exposes a remaining portion of each first electrode except the first end.

In some embodiments, each second electrode comprises a plurality of tooth-like structures extending along the first direction and arranged along a second direction, wherein the second direction intersects with the first direction.

In some embodiments, each of the plurality of tooth-like structures comprises a second surface facing the second conductive layer and a side surface contiguous with the second surface, the first electrode is in direct contact with the side surface of the tooth-like structure.

In some embodiments, in the bonding region, the first insulating layer comprises a plurality of openings, the plurality of openings correspond to the plurality of electrodes one by one, and an orthographic projection of each of the plurality of openings on the base substrate falls within an orthographic projection of a first electrode corresponding to the opening on the base substrate. The electrode further comprises a second end opposite to the first end, and an orthographic projection of the second end of the electrode on the base substrate falls within the orthographic projection of the main part of the first insulating layer on the base substrate.

In some embodiments, in the bonding region, the first insulating layer comprises a plurality of openings, the plurality of openings correspond to the plurality of electrodes one by one, and an orthographic projection of each of the plurality of openings on the base substrate partially overlaps with an orthographic projection of an electrode corresponding to the opening on the base substrate. The electrode further comprises a second end opposite to the first end, a portion of the second end is exposed by an opening corresponding to the electrode.

In some embodiments, an orthographic projection of the second insulating layer on the base substrate does not overlap with orthographic projections of the first electrode and the second electrode on the base substrate, and the first electrode of each electrode is in direct contact with the second electrode of each electrode.

In some embodiments, in the bonding region, the first insulating layer comprises a plurality of openings, the plurality of openings correspond to the plurality of electrodes one by one, and an orthographic projection of each of the plurality of openings on the base substrate falls within an orthographic projection of the first electrode of the electrode corresponding to the opening on the base substrate. The electrode further comprises a second end opposite to the first end, and an orthographic projection of the second end of the electrode on the base substrate falls within the orthographic projection of the main part of the first insulating layer on the base substrate.

In some embodiments, for each electrode, the orthographic projection of the first electrode on the base substrate falls within the orthographic projection of the second electrode on the base substrate.

In some embodiments, the main part of the first insulating layer comprises a plurality of sub-insulating parts extending in the first direction and spaced apart from each other in a second direction intersecting the first direction, orthographic projections of two adjacent sub-insulating parts of the plurality of sub-insulating parts on the base substrate partially overlap with an orthographic projection of an electrode on the base substrate, respectively, and orthographic projections of the first ends of the first electrode and the second electrode on the base substrate partially overlap with the orthographic projections of the two adjacent sub-insulating parts on the base substrate.

In some embodiments, the second conductive layer is arranged only in the functional region, the first conductive layer comprises a third part arranged in the bonding region, the third part comprises a plurality of second electrodes extending along the first direction, and each of the plurality of second electrodes comprises the first end.

In some embodiments, the second insulating layer comprises a plurality of vias, the plurality of vias correspond to the plurality of second electrodes one by one, and an orthographic projection of each of the plurality of vias on the base substrate falls within an orthographic projection of a second electrode corresponding to the via on the base substrate.

In some embodiments, the main part of the first insulating layer comprises a plurality of sub-insulating parts extending in the first direction and spaced apart from each other in a second direction intersecting the first direction, orthographic projections of two adjacent sub-insulating parts of the plurality of sub-insulating parts on the base substrate partially overlap with an orthographic projection of a second electrode on the base substrate, respectively, and an orthographic projection of the first end of the second electrode on the base substrate partially overlaps with the orthographic projections of the two adjacent sub-insulating parts on the base substrate.

According to another aspect of the present disclosure, a light-emitting substrate is provided. The light-emitting substrate comprises the wiring substrate described in any of the preceding embodiments, a plurality of light-emitting elements arranged in the functional region, and a circuit board arranged in the bonding region.

According to still another aspect of the present disclosure, a display device is provided. The display device comprises the wiring substrate described in any of the preceding embodiments or the light-emitting substrate described in any of the preceding embodiments.

According to still another aspect of the present disclosure, there is provided a method of manufacturing a wiring substrate, the method comprising: providing a base substrate comprising a functional region and a bonding region; applying a first conductive film on the base substrate, patterning the first conductive film through a first mask to form a first conductive layer which is at least in the functional region; applying a second conductive film on a side of the first conductive layer away from the base substrate, patterning the second conductive film through a second mask to form a second conductive layer which is at least in the functional region and electrically connected to the first conductive layer; and applying a first insulating film on a side of the second conductive layer away from the base substrate, patterning the first insulating film through a third mask to form a first insulating layer comprising a main part and an opening. At least one of the first conductive layer and the second conductive layer comprises a plurality of electrodes in the bonding region and extending along a first direction, each of the plurality of electrodes comprises a first end adjacent to the functional region in the first direction, and an orthographic projection of the main part of the first insulating layer on the base substrate at least partially overlaps with an orthographic projection of the first end of each electrode on the base substrate.

In some embodiments, after the forming a first conductive layer on the base substrate, the method further comprises: applying a second insulating film on a side of the first conductive layer away from the base substrate, patterning the second insulating film through a fourth mask to form a second insulating layer; and forming the second conductive layer on a side of the second insulating layer away from the base substrate.

### BRIEF DESCRIPTION OF THE DRAWINGS

In order to more clearly describe the technical solutions in the embodiments of the present disclosure, the drawings that need to be used in the embodiments will be briefly introduced in the following. Obviously, the drawings described in the following are only some embodiments of the present disclosure. For those of ordinary skill in the art, other drawings can also be obtained based on these drawings without undue experimentation.
FIG. 1 illustrates a schematic structural diagram of a wiring substrate in the related art;
FIG. 2A illustrates a schematic plan view of a partial structure of a wiring substrate according to an embodiment of the present disclosure;
FIG. 2B illustrates a schematic cross-sectional view taken along the line AA' of FIG. 2A;
FIG. 2C illustrates a simplified schematic diagram of region II of FIG. 2A;
FIG. 3A illustrates an enlarged view of a partial structure of a wiring substrate in the related art;
FIG. 3B illustrates an enlarged view of a partial structure of a wiring substrate in the related art;
FIG. 4 illustrates a schematic plan view of a functional region of a wiring substrate according to an embodiment of the present disclosure;
FIG. 5A illustrates a schematic plan view of a partial structure of a wiring substrate according to an embodiment of the present disclosure;
FIG. 5B illustrates a schematic cross-sectional view taken along the line BB' of FIG. 5A;
FIG. 6A illustrates a schematic plan view of a partial structure of a wiring substrate according to an embodiment of the present disclosure;
FIG. 6B illustrates a schematic cross-sectional view taken along the line CC' of FIG. 6A;
FIG. 7A illustrates a schematic plan view of a partial structure of a wiring substrate according to an embodiment of the present disclosure;
FIG. 7B illustrates a schematic cross-sectional view taken along the line DD' of FIG. 7A;
FIG. 8A illustrates a schematic plan view of a partial structure of a wiring substrate according to an embodiment of the present disclosure;
FIG. 8B illustrates a schematic cross-sectional view taken along the line EE' of FIG. 8A;
FIG. 9A illustrates a schematic plan view of a partial structure of a wiring substrate according to an embodiment of the present disclosure;
FIG. 9B illustrates a schematic cross-sectional view taken along the line FF' of FIG. 9A;
FIG. 10A illustrates a schematic plan view of a partial structure of a wiring substrate according to an embodiment of the present disclosure;
FIG. 10B illustrates a schematic cross-sectional view taken along the line GG' of FIG. 10A;
FIG. 11A illustrates a schematic plan view of a partial structure of a wiring substrate according to an embodiment of the present disclosure;
FIG. 11B illustrates a schematic cross-sectional view taken along the line HH' of FIG. 11A;
FIG. 12 illustrates a block diagram of a light-emitting substrate according to an embodiment of the present disclosure;
FIG. 13 illustrates a block diagram of a display device according to an embodiment of the present disclosure; and
FIG. 14 illustrates a flowchart of a method of manufacturing a wiring substrate according to an embodiment of the present disclosure.

### DETAILED DESCRIPTION OF THE DISCLOSURE

The technical solutions in the embodiments of the present disclosure will be clearly described in the following with reference to the drawings in the embodiments of the present disclosure. Apparently, the described embodiments are only some, but not all, of the embodiments of the present disclosure. Based on the embodiments in the present disclosure, all other embodiments obtained by those of ordinary skill in the art without undue experimentation belong to the protection scope of the present disclosure.

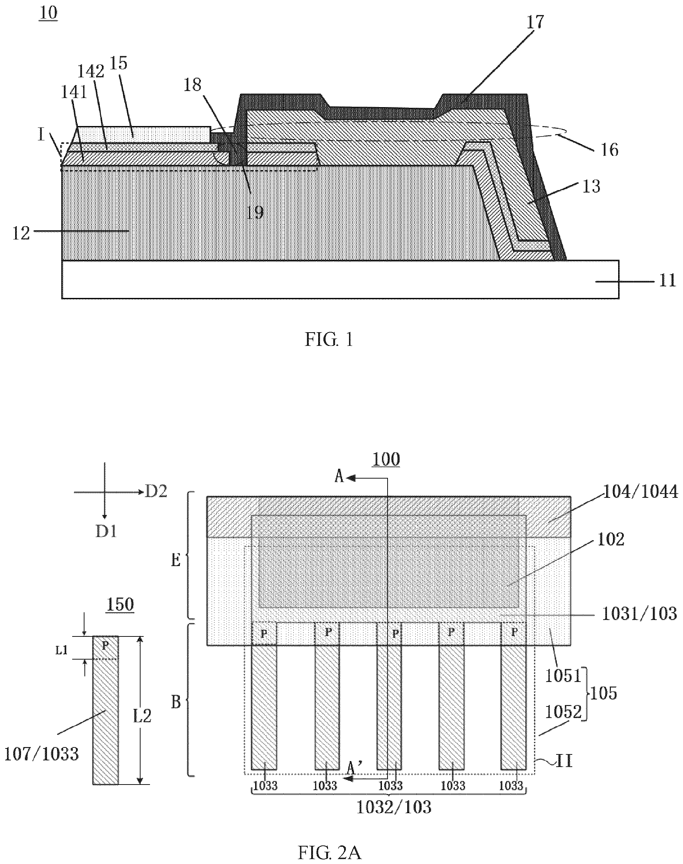

FIG. 1 illustrates a wiring substrate 10 in the related art. The wiring substrate 10 comprises a base substrate 11, a first conductive layer 12, a first sub-insulation layer 141, a second sub-insulation layer 142, a second conductive layer 13, and an insulation layer 15. For the exposed surface of the second conductive layer 13 away from the base substrate 11, an antioxidation treatment is required, for example, by chemical nickel-gold treatment, so as to grow a desired nickel-gold layer 17 on the exposed surface, thereby strengthening the oxidation resistance and/or connection reliability of the second conductive layer 13. Specifically, in the chemical nickel-gold process, the wiring substrate 10 is first acid-washed, and then the wiring substrate 10 is placed in an activation solution comprising Pd²⁺. At this time, the metal (such as Cu) in the exposed region of the surface of the second conductive layer 13 undergoes a substitution reaction with Pd²⁺ in the activation solution to generate Cu²⁺ and Pd (palladium), wherein Pd is attached to the surface of the second conductive layer 13 away from the base substrate 11 to form a palladium layer. Then the wiring substrate 10 is placed in a solution whose main components are nickel sulfate, sodium hypophosphite (reducing agent which reduces nickel ions to metallic nickel), and a complexing agent, and a phosphorus-nickel alloy layer will be formed on the surface of the pad. Since the phosphorus-nickel alloy layer will still be oxidized, it is difficult and unreliable to solder the solder to the oxidized phosphorus-nickel alloy layer. Therefore, finally, it is necessary to immerse the wiring substrate 10 in a solution comprising gold ions to form an immersion gold layer on the surface of the phosphorus-nickel alloy layer. The gold particles in the immersion gold layer can fill the voids in the nickel-gold layer to reduce the oxidation probability of the phosphorus-nickel alloy layer, thereby reducing the oxidation degree of the exposed region of the second conductive layer 13. Thus, the surface of the exposed region of the second conductive layer 13 has a nickel-gold layer 17 (comprising the above-mentioned phosphorus-nickel alloy layer and immersion gold layer).

In the region I circled by the dotted line rectangle in FIG. 1, when the first sub-insulation layer 141 and the second sub-insulation layer 142 are continuous layers without via, they can cover the surface of the first conductive layer 12 to avoid for oxidation. In order to provide a better interface for forming the nickel-gold layer 17 on the surface of the second conductive layer 13, the insulation layer 15 needs to be etched to form a via 16 to expose the second conductive layer 13, and the surface of the second conductive layer 13 away from the base substrate 11 is also etched to a certain extent. Since the surface of the second conductive layer 13 away from the base substrate 11 needs to be etched additionally, the etching time will be increased compared to only etching the insulation layer 15. However, the thickness of the first sub-insulation layer 141 and the second sub-insulation layer 142 is usually relatively thin. In the case of increasing the etching time, it will inevitably cause the first sub-insulation layer 141 and the second sub-insulation layer 142 to be etched, so that an undesired via 19 is generated in the first sub-insulation layer 141 and the second sub-insulation layer 142. The via 16 in the insulation layer 15 and the undesired via 19 in the first sub-insulation layer 141 and the second sub-insulation layer 142 make the surface of the first conductive layer 12 away from the base substrate 11 be partially exposed. The nickel-gold layer 18 will abnormally grow at the exposed position of the surface of the first conductive layer 12. The nickel-gold layer 18 which is abnormally grown may cause problems such as short circuit between layers, damage to the flatness of the surface of the insulation layer 15, etc., thereby significantly affecting the reliability of the wiring substrate 10.

Some embodiments of the present disclosure provide an improved wiring substrate, which can at least solve the problem of abnormal growth of nickel-gold layer in the bonding region.

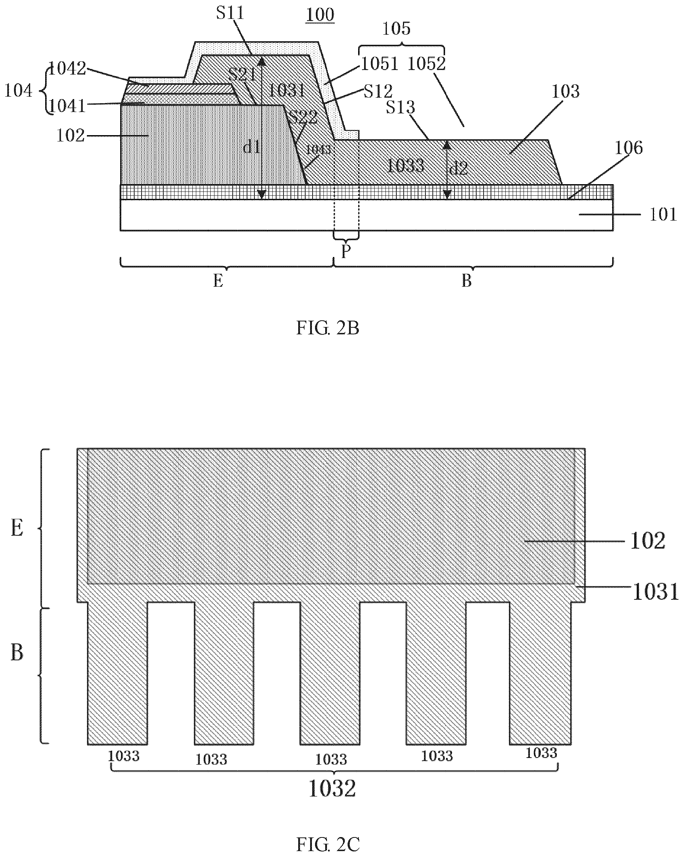

FIG. 2A illustrates a schematic plan view of a partial region of the wiring substrate 100, and FIG. 2B illustrates a cross-sectional view taken along the line AA' of FIG. 2A. As illustrated in FIG. 2A and FIG. 2B, the wiring substrate 100 comprises: a base substrate 101 comprising a functional region E and a bonding region B; a first conductive layer 102 on the base substrate 101 and at least in the functional region E; a second conductive layer 103 on a side of the first conductive layer 102 away from the base substrate 101 and at least in the functional region E, the second conductive layer 103 being electrically connected to the first conductive layer 102; and a first insulating layer 105 on a side of the second conductive layer 103 away from the base substrate 101 and comprising a main part 1051 and an opening 1052. A plurality of electrodes 150 are arranged in the bonding region B, and the plurality of electrodes 150 respectively extend along a first direction D1 and are arranged at intervals along a second direction D2 intersecting the first direction D1, at least one of the first conductive layer 102 and the second conductive layer 103 comprises the plurality of electrodes 150, each of the plurality of electrodes 150 comprises a first end P adjacent to the functional region E in the first direction D1, an orthographic projection of the main part 1051 of the first insulating layer 105 on the base substrate 101 at least partially overlaps with an orthographic projection of the first end P of each electrode 150 on the base substrate 101. The exposed region of the electrode 150 is used as a bonding electrode 107. It should be pointed out that the relative positional relationship among the first conductive layer 102, the second conductive layer 103 and the first insulating layer 105 is not only applicable to the wiring substrate 100, but also applicable to other wiring substrates described in other embodiments of the present disclosure, which will be described in detail later.

It should be noted that, in the present application, the term "the main part 1051 of the first insulating layer 105" refers to the solid portion of the first insulating layer 105, which is made of a suitable insulating material; the term "the opening 1052 of the first insulating layer 105" refers to a via of the first insulating layer 105 without any solid material at the opening 1052 of the first insulating layer 105. The main part 1051 and the opening 1052 constitute the first insulating layer 105. In addition, the term "functional region" refers to a region on the base substrate 101 for arranging functional elements (such as light-emitting elements), the term "bonding region" refers to a region on the base substrate 101 for arranging electrodes 150, the bonding region is used to couple with the circuit board. If the circuit board has a gold finger structure, the width of each of the plurality of electrodes 150 in the bonding region in the second direction is substantially the same, for example, the width of each electrode 150 in the second direction is slightly larger than the width of the gold finger structure in the second direction.

The inventors of the present application found that abnormal growth of nickel-gold tends to occur at the first end P of the electrode 150 in the bonding region B. Therefore, in the embodiments of the present application, by making the orthographic projection of the main part 1051 of the first insulating layer 105 on the base substrate 101 at least partially overlap with the orthographic projection of the first end P of each electrode 150 on the base substrate 101, the main part 1051 of the first insulating layer 105 can cover at least a portion of the first end P of the electrode 150. In this way, even when the first insulating layer 105 is etched to form the opening 1052, since the main part 1051 of the first insulating layer 105 has a shielding and protecting effect on the first end P of the electrode 150, the surface of the first end P of the electrode 150 will not be exposed, thereby reducing or even avoiding the abnormal growth of nickel-gold at the first end P of the electrode 150.

Specifically, referring to FIG. 2A and FIG. 2B, the first conductive layer 102 of the wiring substrate 100 is only arranged in the functional region E but not in the bonding region B, and the second conductive layer 103 comprises a first part 1031 arranged in the functional region E and a second part 1032 arranged in the bonding region B. The second part 1032 of the second conductive layer 103 comprises a plurality of first electrodes 1033 extending along the first direction D1, and the exposed region of each first electrode 1033 is used as the bonding electrode 107. The first electrode 1033 comprises a first end P. The orthographic projection of the first conductive layer 102 on the base substrate 101 does not overlap with the orthographic projection of the first electrode 1033 on the base substrate 101. In some embodiments, the length L1 of the first end P of the first electrode 1033 along the first direction D1 is 30-60 microns, and the length L2 of the first electrode 1033 along the first direction D1 is 1050-1100 microns. In some embodiments, the ratio of the length L1 to the length L2 is between 2% and 6%.

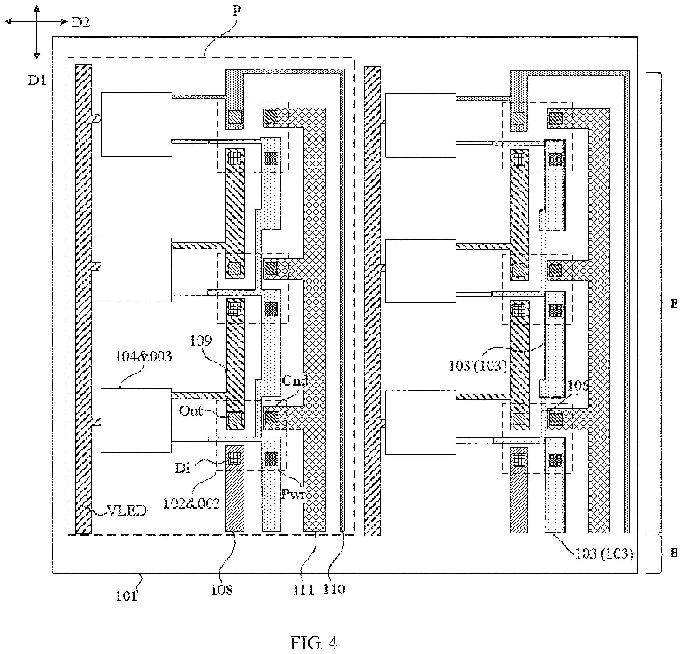

FIG. 2C illustrates a simplified schematic diagram of region II in FIG. 2A, which only illustrates the relative positional relationship between the first conductive layer 102 and the second conductive layer 103. The first conductive layer 102 comprises a driving voltage signal line VLED, a common voltage signal line 111 (illustrated in FIG. 4) and some other signal lines. The driving voltage signal line VLED and/or the common voltage signal line 111 extends approximately along the first direction D1, one end of the driving voltage signal line VLED and/or the common voltage signal line 111 extends to any position on the functional region E of the wiring substrate 100 away from the bonding region B, the other end is connected to the plurality of first electrodes 1033 extending from the bonding region B toward the functional region E. The first conductive layer 102 illustrated in FIG. 2C may represent a driving voltage signal line VLED or a common voltage signal line 111, which is in direct contact with the first part 1031 of the second conductive layer 103 in the functional region E. Since the width of the driving voltage signal line VLED or the common voltage signal line 111 is much larger than the width of the first electrode 1033, the other end of the driving voltage signal line VLED or the common voltage signal line 111 may correspond to and be electrically connected to a plurality of first electrodes 1033.

The inventors of the present application found that in the related art, in the bonding region B, since the surface of the bonding electrode 107 is exposed, and there is a step between the position where the signal line in the first conductive layer 102 is connected to the electrode and the bonding electrode 107, abnormal growth of nickel-gold is likely to occur. However, in the embodiment of the present disclosure, the first conductive layer 102 is only arranged in the functional region E and not in the bonding region B, therefore the driving voltage signal line VLED and the common voltage signal line 111 formed by the first conductive layer 102 are prevented from being abnormally grown nickel-gold in the bonding region B. As can be clearly seen from FIGS. 2A-2C, the orthographic projection of the first conductive layer 102 on the base substrate 101 partially overlaps with the orthographic projection of the first part 1031 of the second conductive layer 103 on the base substrate 101, the orthographic projection of the first conductive layer 102 on the base substrate 101 does not overlap with the orthographic projection of the first electrode 1033 of the second part 1032 of the second conductive layer 103 on the base substrate 101. By making the first conductive layer 102 arranged only in the functional region E and not in the bonding region B, when the first insulating layer 105 is etched to form the opening 1052 in the bonding region B, no matter whether or not the etching time is increased, the occurrence of the above-mentioned abnormal growth of nickel-gold can be avoided.

In some embodiments, the wiring substrate 100 may further comprise a second insulating layer 104 between the first conductive layer 102 and the second conductive layer 103, the first part 1031 of the second conductive layer 103 is electrically connected to the first conductive layer 102 through the via 1043 in the second insulating layer 104. The second insulating layer 104 is only arranged in the functional region E, but not in the bonding region B, therefore, the orthographic projection of the second insulating layer 104 on the base substrate 101 does not overlap with the orthographic projection of the first electrode 1033 on the base substrate 101. If a plurality of stacked insulating layers are arranged in the bonding region B, since the adhesion between the plurality of insulating layers is generally poor, peeling of the insulating layers is likely to occur. When the stacked thickness of the plurality of insulating layers exceeds a threshold (for example, 6000Å), the probability of peeling increases significantly. In order to avoid the problem of peeling in the bonding region B, in the light-emitting substrate 100, as illustrated in FIG. 2A, in the region between any two adjacent first electrodes 1033 among the plurality of first electrodes 1033, the main part 1044 of the second insulating layer 104 is not provided. Therefore, in the region between any two adjacent first electrodes 1033 among the plurality of first electrodes 1033, the orthographic projection of the main part 1051 of the first insulating layer 105 on the base substrate 101 does not overlap with the orthographic projection of the main part 1044 of the second insulating layer 104 on the base substrate 101. In this way, the overlapping of the main part 1051 of the first insulating layer 105 and the main part 1044 of the second insulating layer 104 in the bonding region B can be reduced. Therefore, the peeling phenomenon of the first insulating layer 105 and the second insulating layer 104 in the bonding region B can be reduced or even avoided.

As illustrated in FIG. 2B, the second conductive layer 103 comprises the first part 1031 in the functional region E and the second part 1032 in the bonding region B. The second conductive layer 103 comprises a first surface facing away from the base substrate 101, and the first surface presents a stepped shape. Specifically, the portion of the first surface in the first part 1031 can be designated as a surface S11, the portion of the first surface in the second part 1032 can be designated as a surface S13, and the portion of the first surface which is between the surface S11 and the surface S13 and used to connect the surface S11 and the surface S13 can be designated as a surface S12. The surface S12 is an inclined surface, so that the distance d1 from the surface S11 of the first surface in the first part 1031 to the base substrate 101 is greater than the distance d2 from the surface S13 of the first surface in the second part 1032 to the base substrate 101. The main part 1051 of the first insulating layer 105 is attached to at least the surface S11, the surface S12, and the portion of the surface S13 of each first electrode 1033 that is in the first end P, so as to better cover and protect the first part 1031 of the second conductive layer 103 and the first end P of the first electrode 1033. The orthographic projection of the opening 1052 of the first insulating layer 105 on the base substrate 101 at least partially overlaps with the orthographic projection of the second part 1032 on the base substrate 101. In some embodiments, the orthographic projection of the opening 1052 of the first insulating layer 105 on the base substrate 101 does not overlap with the orthographic projection of the second insulating layer 104 on the base substrate 101. The flexible printed circuit board can be bonded to the region of the first electrode 1033 except the first end P, that is, the flexible printed circuit board is bonded to the bonding electrode.

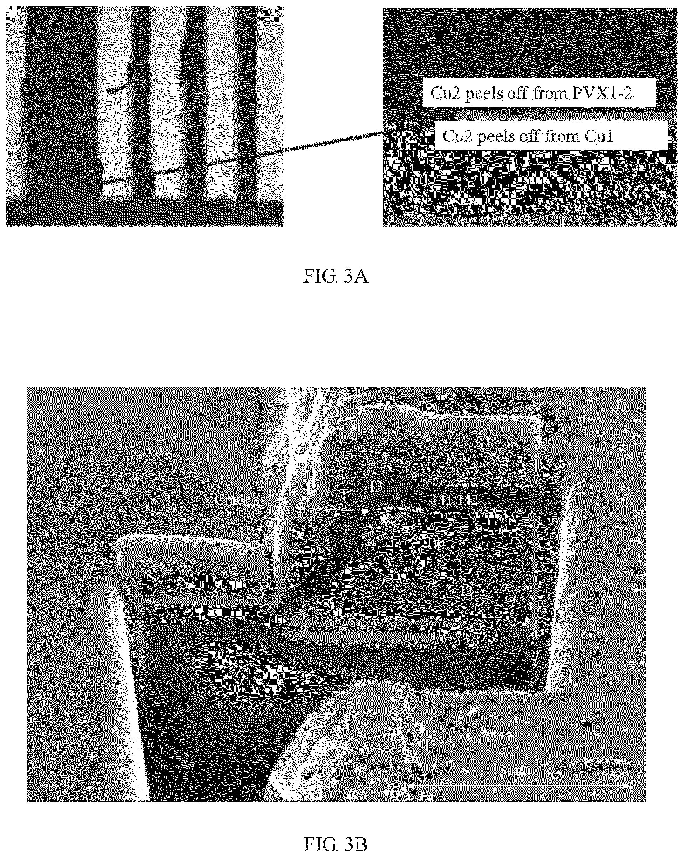

In some embodiments, the first conductive layer 102 comprises a second surface S21 facing the second conductive layer 103 and a side surface S22 contiguous with the second surface S21 and facing the bonding region B, the second insulating layer 104 covers a portion of the second surface S21 of the first conductive layer 102 but does not cover the side surface S22 of the first conductive layer 102, the second conductive layer 103 is in direct contact with the side surface S22 of the first conductive layer 102 through the via 1043 in the second insulating layer 104. The second insulating layer 104 may be a single layer, or a stack of multiple layers. In an example, the second insulating layer 104 comprises a first sub-insulating layer 1041 and a second sub-insulating layer 1042. In the direction perpendicular to the base substrate 101, compared with the thickness of the first conductive layer 102, the thickness of the second insulating layer 104 is generally thinner. In an example, the thickness of the first conductive layer 102 in the direction perpendicular to the base substrate 101 is 1.8µm, the thickness of the first sub-insulating layer 1041 in the direction perpendicular to the base substrate 101 is 0.24µm, the thickness of the second sub-insulating layer 1042 in the direction perpendicular to the base substrate 101 is 0.15µm. In the related art, the second insulating layer 104 needs to cover the side surface S22 of the first conductive layer 102. Since there is a larger step difference between the second surface S21 of the first conductive layer 102 and the surface of the underlying layer, the second insulating layer 104 is likely to break at the position where the second surface S21 of the first conductive layer 102 connects to the side surface S22, so that the second insulating layer 104 cannot completely cover and protect the first conductive layer 102. In addition, after the second insulating layer 104 breaks, the subsequently formed second conductive layer 103 cannot achieve good contact with the underlying layer at the broken position, which causes the peeling of the second conductive layer 103. Further, since the second insulating layer 104 is broken, the surface of a portion of the first conductive layer 102 will be exposed, thereby oxidizing and forming metal oxides with irregular shape, reducing the continuity and flatness of the first conductive layer 102. If the second conductive layer 103 is in direct contact with the region of the first conductive layer 102 having the oxides with irregular shape, it is easy to cause the second conductive layer 103 to bulge there, and then cause the peeling of the second conductive layer 103. Therefore, if the second insulating layer 104 is arranged at the side surface S22 of the first conductive layer 102, it is easy to cause the peeling of the second conductive layer 103. FIG. 3A illustrates the peeling of the second conductive layer 103 and the second insulating layer (PVX1-2) at the side surface of the first conductive layer (Cu1) in the related art, and the peeling of the second conductive layer (Cu2) and the first conductive layer (Cu1) at the side surface of the first conductive layer (Cu1). FIG. 3B illustrates a crack in the first sub-insulating layer 141 or the second sub-insulating layer 142 due to the step difference in the first conductive layer 12 in the related art, the first conductive layer 12 is in turn oxidized at the corresponding position to form an irregular-shaped (Tip) oxide, which finally causes the second conductive layer 13 to bulge.

In the wiring substrate 100 provided by the embodiment of the present disclosure, the second insulating layer 104 does not cover the side surface S22 of the first conductive layer 102, instead, the second conductive layer 103 is in direct contact with the side surface S22 of the first conductive layer 102 through the via 1043 in the second insulating layer 104. In this way, the second insulating layer 104 will not be broken, so that the first electrode 1033 of the second conductive layer 103 will not fall off from the second insulating layer 104 due to contact with the broken second insulating layer 104. Further, since the second insulating layer 104 will not be broken, the side surface S22 of the first conductive layer 102 will not have an irregular surface morphology due to oxidation of the exposed surface. Therefore, the second conductive layer 103 will not be bulged, and the problem of peeling between the first electrode 1033 of the second conductive layer 103 and the first conductive layer 102 will not be caused.

In some embodiments, the first conductive layer 102 may be a stack of MoNb/Cu/MoNb. In an alternative embodiment, the first conductive layer 102 may be a stack of Mo/Cu/Mo. In some embodiments, the second conductive layer 103 may be a stack of MoNb (300Å)/Cu (6000~9000Å)/MoNb (300Å). In an alternative embodiment, the second conductive layer 103 may be a stack of Mo (300Å)/Cu (6000~9000Å)/Mo (17~30Å). The thickness of the first conductive layer 102 is generally greater than the thickness of the second conductive layer 103.

As illustrated in FIG. 2B, in some embodiments, the wiring substrate 100 may further comprise a buffer layer 106 between the base substrate 101 and the first conductive layer 102. The buffer layer 106 has a planarization effect and can improve the adhesion between the first conductive layer 102 and the base substrate 101.

FIGS. 2A-2C mainly illustrate the layout of the wiring substrate 100 in the bonding region B. In order to make readers understand the overall layout of the wiring substrate 100 more clearly, FIG. 4 illustrates the layout of the wiring substrate 100 in the functional region E as an example.

The functional region of the wiring substrate 100 is provided with pad groups to be bonded to tens of thousands of electronic components. Referring to FIG. 4, the wiring substrate 100 comprises in the functional region E: a first pad group 102 on the base substrate 101, the first pad group 102 comprises a power supply pad Pwr and an output pad Out, and optionally, the first pad group 102 is coupled to the micro driver chip 002; a power signal line 103 on the same side of the base substrate 101 as the first pad group 102, and the power signal line 103 couples to the power supply pad Pwr; a second pad group 104 on the same side of the base substrate 101 as the first pad group 102, and optionally, each second pad group 104 couples to an electronic element 003. The exposed region of the second conductive layer 103 in the functional region E constitutes the above-mentioned first pad group 102 and the second pad group 104. Specifically, the first insulating layer 105 comprises an opening 1052 in the functional region E, and the opening 1052 exposes a portion of the second conductive layer 103 for use as a pad. The first pad group 102 can be coupled with the micro driver chip 002 through a reflow process with the aid of solder, and the second pad group 104 can be coupled with the light-emitting element 003 through a reflow process with the aid of solder. The portion of the second conductive layer 103 exposed by the opening 1052 in the bonding region B is used as a bonding electrode (for example, the portion of the first electrode 1033 except the first end P). With the aid of anisotropic conductive adhesive, the bonding electrode is bonded to the gold finger structure of the circuit board (such as FPC) through a hot pressing process. In some embodiments, the base substrate 101 comprises a plurality of pad regions P, and each pad region P comprises a plurality of cascaded first pad groups 102 and a plurality of second pad groups 104 respectively coupled to the first pad groups 102. Optionally, in one pad region P, a plurality of cascaded first pad groups 102 may be arranged in an array along the first direction D1 and/or the second direction D2, which is not limited herein. FIG. 4 illustrates schematically by taking a plurality of cascaded first pad groups 102 arranged in a row in one pad region P as an example. In some embodiments, one power signal line 103 may be coupled to the power supply pads Pwr of the plurality of first pad groups 102 arranged and cascaded along the first direction D1 in one pad region P, which can reduce the winding design of the power signal line 103, thereby reducing the resistance of the power signal line 103, and further reducing the loss of the pulse width modulation signal on the power signal line 103. In some embodiments, the wiring substrate 100 may further comprise a first connection lead 106, a power signal line 103 comprises a plurality of subsections 103', and two adjacent subsections 103' in the first direction D1 may be connected to each other through a first connection lead 106, so as to realize that the same power signal line 103 supplies power to the power supply pads Pwr of the plurality of first pad groups 102 arranged and cascaded along the first direction D1 in the same pad region P. Optionally, the first connection lead 106 and the subsection 103' are an integral. In some embodiments, the first pad group 102 further comprises an address pad Di and a ground pad Gnd, the address pad Di and the power supply pad Pwr belonging to the same first pad group 102 are arranged at intervals in the second direction D2, and the address pad Di and the output pad Out belonging to the same first pad group 102 are arranged at intervals in the first direction D1. The ground pad Gnd is spaced from the power supply pad Pwr in the first direction D1, and spaced from the output pad Out in the second direction D2. Exemplarily, the output pad Out is at the upper left corner of the first pad group 102, the address pad Di is at the lower left corner of the first pad group 102, the ground pad Gnd is at the upper right corner of the first pad group 102, and the power supply pad Pwr is at the lower right corner of the first pad group 102. Each first pad group 102 can be coupled with a micro driver chip 002, and each second pad group 104 can be coupled with a plurality of electronic elements 003. In some embodiments, the address pad Di can receive an address signal for gating the corresponding address of the micro driver chip 002. The power supply pad Pwr can provide the micro driver chip 002 with a first working voltage and communication data, and the communication data can be used to control the luminance of the corresponding light-emitting elements. The output pad Out can respectively output a relay signal and a drive signal in different time periods, the relay signal is an address signal provided to the address pad Di of the next cascaded first pad group 102, and the drive signal is a drive current, which is used to drive the light-emitting elements coupled to the first pad group 102 where the output pad Out is located to emit light. The ground pad Gnd receives a common voltage signal. In some embodiments, in each first pad group 102, the power supply pad Pwr, the output pad Out, the ground pad Gnd, and the address pad Di are arranged in the same manner, in order to have a simple routing path between the cascaded first pad groups 102 in the same pad region P, avoiding wiring.

In some embodiments, the wiring substrate 100 may further comprise address signal lines 108, and one address signal line 108 may be coupled to the address pad Di of the first cascaded first pad group 102 in the pad region P, so that in each pad region P, the address signal provided by the address signal line 107 is received through the address pad Di of the first cascaded first pad group 102. In some embodiments, the wiring substrate 100 may further comprise a cascade line 109. The cascade line 109 is configured to connect the output pad Out of the nth-cascaded first pad group 102 and the address pad Di of the (n+1)^{th}-cascaded first pad group 102 which belong to the same pad region P, n is a positive integer. The relay signal output from the output pad Out of the nth-cascaded first pad group 102 is provided to the address pad Di of the (n+1)^{th}-cascaded first pad group 102 through the cascade line 109. In some embodiments, the wiring substrate 100 may further comprise feedback signal lines 110, and one feedback signal line 110 is coupled to the output pad Out of the last cascaded first pad group 102 in a pad region P, so as to form a loop for transmitting address signals in the pad region P. In some embodiments, the wiring substrate 100 may further comprise common voltage signal lines 111, and one common voltage signal line 111 is coupled to the ground pads Gnd of all first pad groups 102 in one pad region P. In some embodiments, the wiring substrate 100 may further comprise driving voltage signal lines VLED for coupling with the electronic elements 003.

Taking FIG. 4 as an example, in the functional region E of the wiring substrate, the first conductive layer 102 is configured to realize the power signal line 103, the first connection lead 106, the second connection lead 107, the address signal line 108, the cascade line 109, the feedback signal line 110, the common voltage signal line 111, the driving voltage signal line VLED, and the connecting lines (not illustrated) connecting the first pad group with the second pad group and connecting the second pad group with the second pad group. During the manufacturing process, these signal lines are formed by patterning the first conductive layer 102 through a patterning process by using the same mask.

It can be understood that, in some other embodiments, in the functional region E of the wiring substrate, the first conductive layer 102 is only configured to implement the power signal line 103, the address signal line 108, the feedback signal line 110, the common voltage signal line 111 and the driving voltage signal line VLED, and the second conductive layer 103 is configured to realize the first connection lead 106, the second connection lead 107, the cascade line 109, and the connecting lines connecting the first pad group with the second pad group and connecting the second pad group with the second pad group.

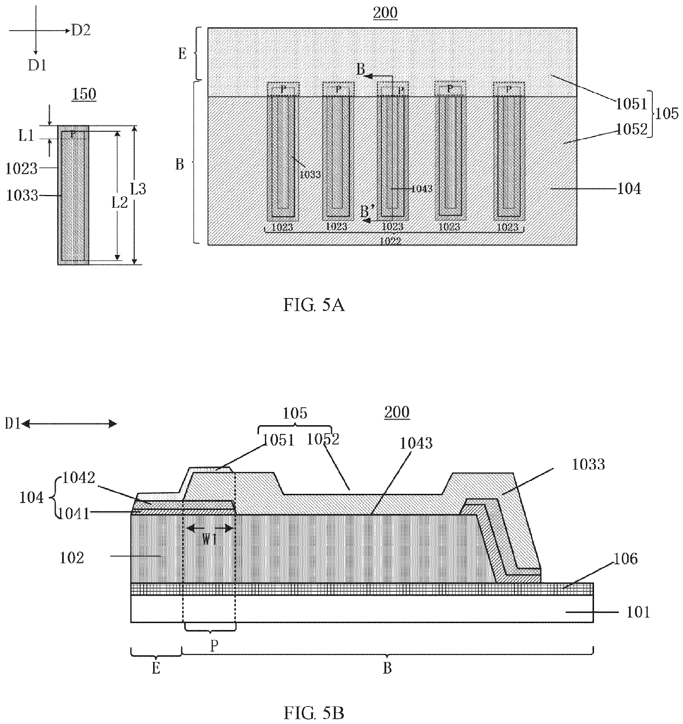

FIG. 5A illustrates a schematic plan view of a partial structure of the wiring substrate 200 in the bonding region B and the functional region E, and FIG. 5B illustrates a cross-sectional view taken along line BB' in FIG. 5A. For the sake of brevity, the similarities between the wiring substrate 200 and the wiring substrate 100 will not be described, and only the differences between the wiring substrate 200 and the wiring substrate 100 will be described below.

The wiring substrate 200 illustrated in FIG. 5A comprises structures such as a base substrate 101, a first conductive layer 102, a second conductive layer 103, a first insulating layer 105, and a second insulating layer 104. Different from the wiring substrate 100, the first conductive layer 102 of the wiring substrate 200 is arranged in the functional region E and the bonding region B, the first conductive layer 102 comprises a third part 1022 in the bonding region B, the third part 1022 comprises a plurality of second electrodes 1023 extending along the first direction D1 and arranged at intervals along the second direction D2. The second conductive layer 103 comprises a first part 1031 in the functional region E and a second part 1032 in the bonding region B. The second part 1032 comprises a plurality of first electrodes 1033 extending along the first direction D1. The plurality of first electrodes 1033 correspond to the plurality of second electrodes 1023 one by one, the orthographic projection of each first electrode 1033 on the base substrate 101 falls within the orthographic projection of a corresponding second electrode 1023 on the base substrate 101, each first electrode 1033 is electrically connected to a second electrode 1023 corresponding to the first electrode 1033 to form an electrode, and the exposed region of the surface of the electrode is used as the bonding electrode 107. Both the first electrode 1033 and the second electrode 1023 comprise the first end P close to the functional region E. The orthographic projection of the first ends P of the first electrode 1033 and the second electrode 1023 on the base substrate 101 falls within the orthographic projection of the main part 1051 of the first insulating layer 105 on the base substrate 101. In some embodiments, the opening 1052 of the first insulating layer 105 exposes the remaining region of each first electrode 1033 except the first end P.

The driving voltage signal line VLED and the common voltage signal line 111 belonging to the first conductive layer 102 and in the functional region E are bonded to the electrode at the first end P of the electrode. As mentioned above, in the related art, the exposed surface of the driving voltage signal line VLED and the common voltage signal line 111 at the first end P may easily lead to abnormal growth of nickel-gold. In the wiring substrate 200 provided in the embodiment of the present disclosure, the electrode comprises the second electrode 1023 and the first electrode 1033 on the side of the second electrode 1023 away from the base substrate 101, the orthographic projection of the first end P of the electrode on the base substrate 101 falls within the orthographic projection of the main part 1051 of the first insulating layer 105 on the base substrate 101. That is to say, there is at least the first electrode 1033 between the main part 1051 of the first insulating layer 105 and the second electrode 1023. With such an arrangement, when the first insulating layer 105 is etched, even if the etching time is increased, at most, the surface of the first electrode 1033 facing away from the base substrate 101 may be over-etched. Since the first electrode 1033 with a thicker thickness (compared to the thickness of the second insulating layer 104) shields and protects the second electrode 1023, the first end P of the second electrode 1023 will not be etched, so that the surface of the first end P of the second electrode 1023 will not be exposed. Correspondingly, the first end of the second electrode 1023 of each signal line will not be exposed, so that the abnormal growth of nickel-gold will not occur.

In some embodiments, the length L1 of the first end P of the first electrode 1033 along the first direction D1 is 30-60 microns, the length L2 of the first electrode 1033 along the first direction D1 is 1050-1100 microns, and the length L3 of the second electrode 1023 along the first direction D1 is 1066-1116 microns. In some embodiments, the ratio of the length L1 to the length L2 is between 2% and 6%, and the ratio of the length L1 to the length L3 is between 2% and 6%.

In some embodiments, the second insulating layer 104 comprises a plurality of vias 1043 in the bonding region B, the plurality of vias 1043 correspond to the plurality of electrodes one by one, and the orthographic projection of each via 1043 on the base substrate 101 falls within the orthographic projection of the first electrode 1033 of the corresponding electrode on the base substrate 101. As illustrated in FIG. 5B, in an example, the second insulating layer 104 extends along the first direction D1 and covers a portion of the surface of the second electrode 1023 of the first conductive layer 102 in the bonding region B. For example, the second insulating layer 104 may cover and protect a portion of the surface of the first end P of the second electrode 1023 close to the functional region E, for example, W1 is about 22µm.

It should be noted that FIG. 5A only illustrates a schematic structural diagram of the wiring substrate 200 in a partial region, and the schematic diagram does not illustrate the electrical connection relationship between the third part 1022 and various signal lines in the functional region E. In fact, in the wiring substrate 200, the third part 1022 is electrically connected to various signal lines, such as power signal lines 103, address signal lines 108, feedback signal lines 110, common voltage signal lines 111, and driving voltage signal lines VLED.

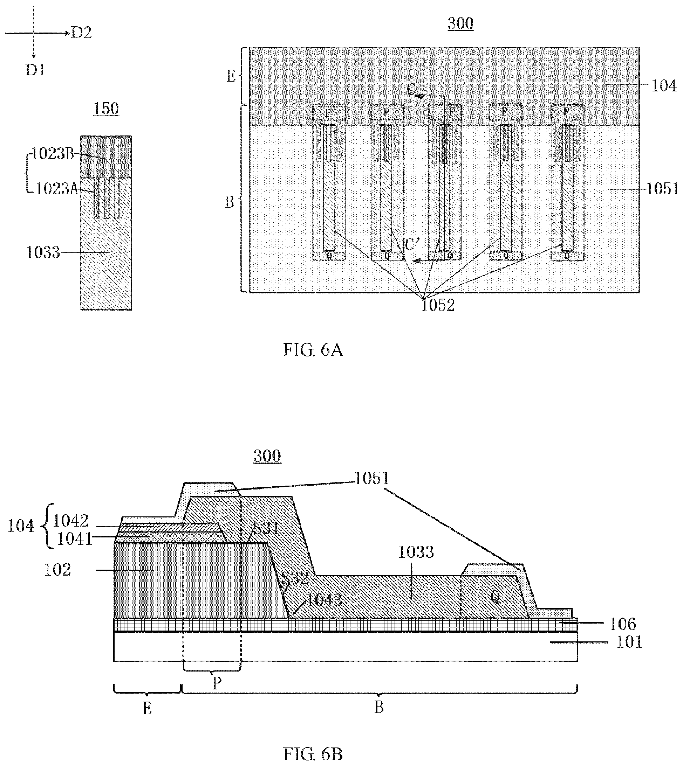

FIG. 6A illustrates a schematic plan view of a partial structure of the wiring substrate 300 in the bonding region B and the functional region E, and FIG. 6B illustrates a cross-sectional view taken along the line CC' in FIG. 6A. For the sake of brevity, the similarities between the wiring substrate 300 and the wiring substrate 100 will not be described, and only the differences between the wiring substrate 300 and the wiring substrate 100 will be described below.

The wiring substrate 300 illustrated in FIG. 6A comprises structures such as a base substrate 101, a first conductive layer 102, a second conductive layer 103, a first insulating layer 105, and a second insulating layer 104. Different from the wiring substrate 100, the first conductive layer 102 of the wiring substrate 200 is arranged in the functional region E and the bonding region B, the first conductive layer 102 comprises a third part 1022 in the bonding region B, and the third part 1022 comprises a plurality of second electrodes 1023 extending along the first direction D1. The second conductive layer 103 comprises a first part 1031 in the functional region E and a second part 1032 in the bonding region B. The second part 1032 comprises a plurality of first electrodes 1033 extending along the first direction D1. The plurality of first electrodes 1033 correspond to the plurality of second electrodes 1023 one by one, and the orthographic projection of each second electrode 1023 on the base substrate 101 falls within the orthographic projection of a corresponding first electrode 1033 on the base substrate 101. Each first electrode 1033 is electrically connected to a second electrode 1023 corresponding to the first electrode 1033 to form an electrode, and the exposed region of the electrode forms a bonding electrode. Both the first electrode 1033 and the second electrode 1023 comprise a first end P close to the functional region E. The orthographic projection of the first end P of the first electrode 1033 on the base substrate 101 falls within the orthographic projection of the main part 1051 of the first insulating layer 105 on the base substrate 101. With such an arrangement, when the first insulating layer 105 is etched, even if the etching time is increased, at most, the surface of the first electrode 1033 facing away from the base substrate 101 may be over-etched. Since the first electrode 1033 is thicker compared to the second insulating layer 104, the first electrode 1033 can shield and protect the second electrode 1023 during the etching process. Therefore, the side surface S32 of the first end P of the second electrode 1023 will not be etched, so that the side surface S32 will not be exposed. That is, the first ends of the second electrodes 1023 of various signal lines will not be exposed, so that the abnormal growth of nickel-gold will not occur.

As illustrated in FIG. 6A, each second electrode 1023 comprises a plurality of tooth-like structures 1023A extending along the first direction D1 and arranged along the second direction D2 intersecting the first direction D1. Each second electrode 1023 further comprises a connection structure 1023B arranged along the second direction D2, and the plurality of tooth-like structures 1023A belonging to the same signal line are connected to each other through the connection structure 1023B. The connection structure 1023B may have the same width as the portion of the signal line arranged in the functional region E. Assuming that the two metal layers have the same surface area, the thicker one has a larger surface roughness. When the two metal layers are in direct contact, it is easy to generate lateral sliding shear force on the contact surface, which makes the adhesion between the two layers worse, resulting in the problem of peeling. In the wiring substrate 300 provided in the embodiment of the present disclosure, the shape of the portion of the thicker second electrode 1023 which is in direct contact with the first electrode 1033 is designed as a comb shape, so that the contact area between the second electrode 1023 and the first electrode 1033 can be increased. Therefore, the sliding shear force between the two is reduced, the adhesion force between the second electrode 1023 and the first electrode 1033 is increased, and the problem of peeling between the second electrode 1023 and the first electrode 1033 is avoided.

Each tooth-like structure 1023A comprises a second surface S31 facing the second conductive layer 103 and a side surface S32 contiguous with the second surface S31. The via 1043 of the second insulating layer 104 exposes at least the side surface S32 of each tooth-like structure 1023A, so that the first electrode 1033 directly contacts with the side surface S32 of the tooth-like structure 1023A through the via 1043 in the second insulating layer 104. In other words, the second insulating layer 104 does not cover the side surface S32 of the tooth-like structure 1023A. With such an arrangement, the second insulating layer 104 will not break at the side surface S32 of the tooth-like structure 1023A, so that the first electrode 1033 will not fall off from the second insulating layer 104 due to contact with the broken second insulating layer 104. Further, since the second insulating layer 104 will not broke at the side surface S32 of the tooth-like structure 1023A, the side surface S32 of the tooth-like structure 1023A will not be exposed to be oxidized to produce oxide, so that the first electrode 1033 will not be bulged there, and the problem of peeling between the first electrode 1033 and the second electrode 1023 will not be caused.

As illustrated in FIGS. 6A and 6B, in the bonding region B, the first insulating layer 105 comprises a plurality of openings 1052, the plurality of openings 1052 correspond to the plurality of first electrodes 1033 one by one, and the orthographic projection of each opening 1052 on the base substrate 101 falls within the orthographic projection of the first electrode 1033 corresponding to the opening 1052 on the base substrate 101. Each first electrode 1033 also comprises a second end Q opposite to the first end P. The orthographic projections of the first end P and the second end Q of each first electrode 1033 on the base substrate 101 fall within the orthographic projection of the main part 1051 of the first insulating layer 105 on the base substrate 101. By making the area of the opening 1052 smaller than the area of the first electrode 1033, both the first end P and the second end Q of the first electrode 1033 can be covered by the main part 1051 of the first insulating layer 105, thereby enhancing the corrosion resistance of the bonding electrode 107.

It should be noted that FIG. 6A only illustrates a schematic structural diagram of a partial region of the wiring substrate 300, and the schematic diagram does not illustrate the electrical connection relationship between the third part 1022 and various signal lines in the functional region E. In fact, in the wiring substrate 300, the third part 1022 is electrically connected to various signal lines in the first conductive layer 102, such as the power signal line 103, the address signal line 108, the feedback signal line 110, the common voltage signal line 111, and the driving voltage signal line VLED.

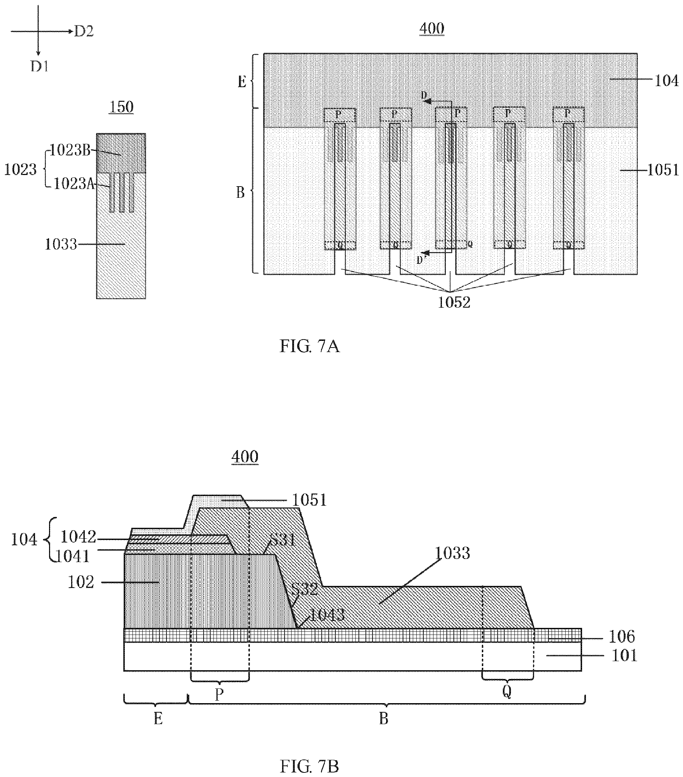

FIG. 7A illustrates a schematic plan view of a partial structure of a wiring substrate 400 in the bonding region B and the functional region E, and FIG. 7B illustrates a cross-sectional view taken along the line DD' in FIG. 7A. The structure of the wiring substrate 400 is substantially the same as that of the wiring substrate 300 except that the opening 1052 of the first insulating layer 105 is different from that of the wiring substrate 300. For the sake of brevity, only the differences between the wiring substrate 400 and the wiring substrate 300 will be described below.

As illustrated in FIGS. 7A and 7B, in the bonding region B, the first insulating layer 105 comprises a plurality of openings 1052, the plurality of openings 1052 correspond to the plurality of first electrodes 1033 one by one, and the orthographic projection of each opening 1052 on the base substrate 101 partially overlaps with the orthographic projection of the first electrode 1033 corresponding to the opening 1052 on the base substrate 101. Each first electrode 1033 also comprises a second end Q opposite to the first end P, the orthographic projection of the first end P of each first electrode 1033 on the base substrate 101 falls within the orthographic projection of the main part 1051 of the first insulating layer 105 on the base substrate 101, and the second end Q of each first electrode 1033 is exposed by an opening 1052. With such an arrangement, the main part 1051 of the first insulating layer 105 is not disposed on the second end Q of the first electrode 1033, so that the problem of peeling caused by the existence of the first insulating layer 105 can be effectively reduced.

It should be noted that FIG. 7A only illustrates a schematic structural diagram of a partial region of the wiring substrate 400, and the schematic diagram does not illustrate the electrical connection relationship between the third part 1022 and various signal lines in the functional region E. In fact, in the wiring substrate 400, the third part 1022 is electrically connected to various signal lines in the first conductive layer 102, such as the power signal line 103, the address signal line 108, the feedback signal line 110, the common voltage signal line 111, and the driving voltage signal line VLED.

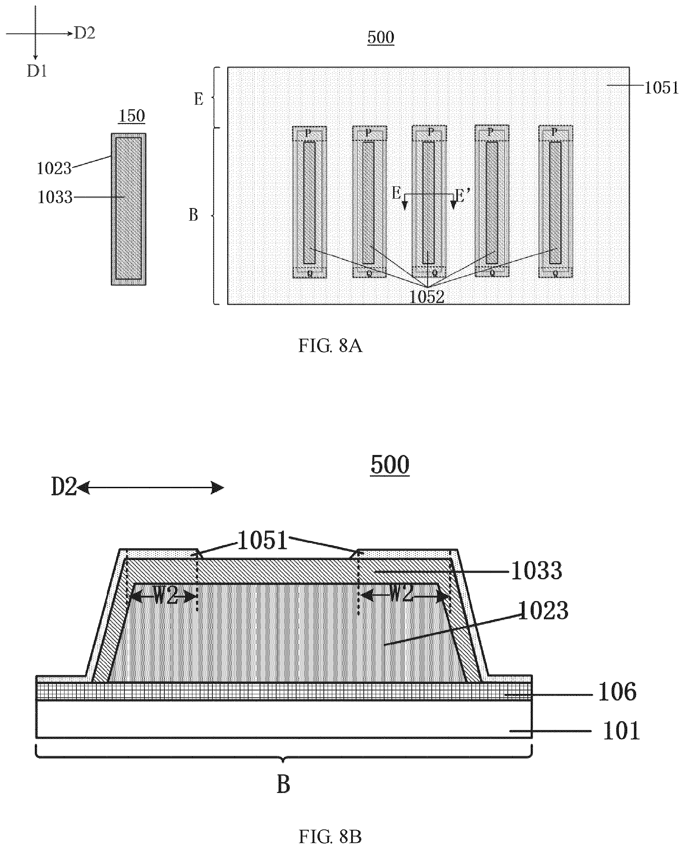

FIG. 8A illustrates a schematic plan view of a partial structure of a wiring substrate 500 in the bonding region B and the functional region E, and FIG. 8B illustrates a cross-sectional view taken along the line EE' in FIG. 8A. For the sake of brevity, the similarities between the wiring substrate 500 and the wiring substrate 100 will not be described, and only the differences between the wiring substrate 500 and the wiring substrate 100 will be described below.

The wiring substrate 500 illustrated in FIG. 8A comprises structures such as a base substrate 101, a first conductive layer 102, a second conductive layer 103, a first insulating layer 105, and a second insulating layer 104. Different from the wiring substrate 100, the first conductive layer 102 of the wiring substrate 500 is arranged in the functional region E and the bonding region B. The first conductive layer 102 comprises a third part 1022 in the bonding region B, and the third part 1022 comprises a plurality of second electrodes 1023 extending along the first direction D1. The second conductive layer 103 comprises a first part 1031 in the functional region E and a second part 1032 in the bonding region B. The second part 1032 comprises a plurality of first electrodes 1033 extending along the first direction D1. The plurality of first electrodes 1033 correspond to the plurality of second electrodes 1023 one by one, and the orthographic projection of each first electrode 1033 on the base substrate 101 falls within the orthographic projection of a corresponding second electrode 1023 on the base substrate 101. Each first electrode 1033 and a second electrode 1023 corresponding to the first electrode 1033 constitute an electrode, and the exposed region of the electrode constitutes a bonding electrode 107. The electrode comprises a first end P close to the functional region E. The orthographic projection of the first end P of the electrode on the base substrate 101 falls within the orthographic projection of the main part 1051 of the first insulating layer 105 on the base substrate 101. With such an arrangement, when the first insulating layer 105 is etched, even if the etching time increases, at most, the surface of the first electrode 1033 facing away from the base substrate 101 may be over-etched. Since the thickness of the first electrode 1033 is greater than the thickness of the second insulating layer 104, the first electrode 1033 has a shielding and protective effect on the second electrode 1023, so the first end P of the second electrode 1023 will not be etched. Therefore, the first end P of the second electrode 1023 will not be exposed. That is, the first ends of the second electrodes 1023 of various signal lines will not be exposed, so that the abnormal growth of nickel-gold will not occur.

It should be noted that FIG. 8A only illustrates a schematic structural diagram of a partial region of the wiring substrate 500, and the schematic diagram does not illustrate the electrical connection relationship between the third part 1022 and various signal lines in the functional region E. In fact, in the wiring substrate 500, the third part 1022 is electrically connected to various signal lines in the first conductive layer 102, such as the power signal line 103, the address signal line 108, the feedback signal line 110, the common voltage signal line 111, and the driving voltage signal line VLED. In addition, the second insulating layer 104 is arranged only in the functional region E and not in the bonding region B. Therefore, the orthographic projection of the second insulating layer 104 on the base substrate 101 does not overlap with the orthographic projections of the first electrode 1033 and the second electrode 1023 on the base substrate 101, and the first electrode 1033 and the second electrode 1023 constituting the electrode are directly connected to each other. By not disposing the second insulating layer 104 in the bonding region B, the peeling problem caused by the overlapping of multiple insulating layers in the bonding region B can be effectively reduced.

In the bonding region B, the first insulating layer 105 comprises a plurality of openings 1052, the plurality of openings 1052 correspond to the plurality of electrodes one by one, and the orthographic projection of each opening 1052 on the base substrate 101 falls within the orthographic projection of an electrode corresponding to the opening 1052 on the base substrate 101. The electrode formed by the first electrode 1033 and the second electrode 1023 corresponding to the first electrode 1033 also comprises a second end Q opposite to the first end P, the orthographic projections of the first end P and the second end Q of each electrode on the base substrate 101 fall within the orthographic projection of the main part 1051 of the first insulating layer 105 on the base substrate 101. As illustrated in FIG. 8B, in an example, the overlapping width W2 of the main part 1051 of the first insulating layer 105 and the first electrode 1033 along the second direction D2 is about 30µm. By making the area of the opening 1052 smaller than that of the first electrode 1033, both the first end P and the second end Q of the electrode can be covered by the main part 1051 of the first insulating layer 105, thereby enhancing the corrosion resistance of the electrode.

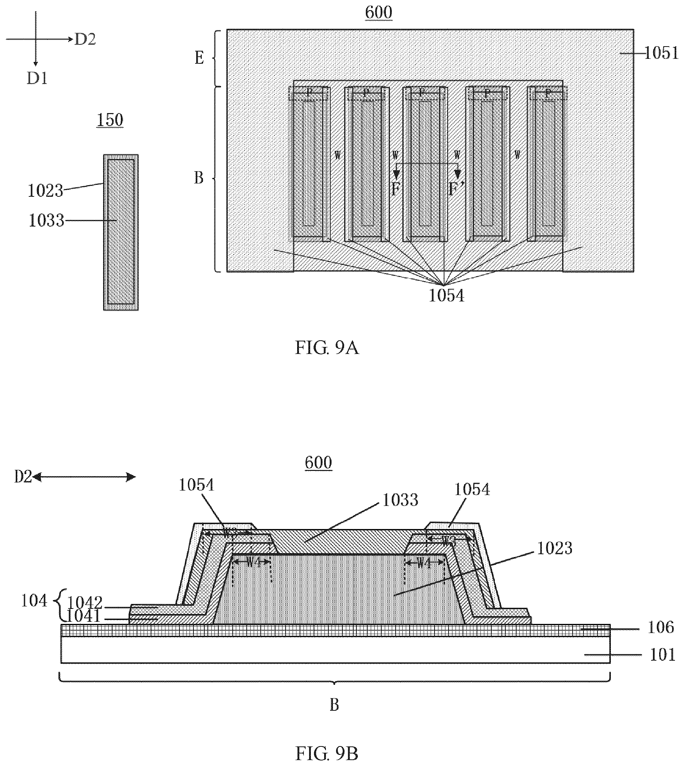

FIG. 9A illustrates a schematic plan view of a partial structure of a wiring substrate 600 in the bonding region B and the functional region E, and FIG. 9B illustrates a cross-sectional view taken along the line FF' in FIG. 9A. For the sake of brevity, the similarities between the wiring substrate 600 and the wiring substrate 100 will not be described, and only the differences between the wiring substrate 600 and the wiring substrate 100 will be described below.

The wiring substrate 600 illustrated in FIG. 9A comprises structures such as a base substrate 101, a first conductive layer 102, a second conductive layer 103, a first insulating layer 105, and a second insulating layer 104. Different from the wiring substrate 100, the first conductive layer 102 of the wiring substrate 600 is arranged in the functional region E and the bonding region B. The first conductive layer 102 comprises a third part 1022 in the bonding region B, and the third part 1022 comprises a plurality of second electrodes 1023 extending along the first direction D1. It should be noted that FIG. 9A only illustrates a schematic structural diagram of a partial region of the wiring substrate 600, and the schematic diagram does not illustrate the electrical connection relationship between the third part 1022 and various signal lines in the functional region E. In fact, in the wiring substrate 600, the third part 1022 is electrically connected to various signal lines in the first conductive layer 102, such as the power signal line 103, the address signal line 108, the feedback signal line 110, the common voltage signal line 111, and the driving voltage signal line VLED.

The second conductive layer 103 comprises a first part 1031 in the functional region E and a second part 1032 in the bonding region B. The second part 1032 comprises a plurality of first electrodes 1033 extending along the first direction D1. The plurality of first electrodes 1033 correspond to the plurality of second electrodes 1023 one by one, and the orthographic projection of each first electrode 1033 on the base substrate 101 falls within the orthographic projection of a corresponding second electrode 1023 on the base substrate 101. A first electrode 1033 and a second electrode 1023 corresponding to the first electrode 1033 constitute an electrode, and the exposed region of the electrode constitutes a bonding electrode 107. The electrode comprises a first end P close to the functional region E.

As illustrated in FIG. 9A, the main part 1051 of the first insulating layer 105 comprises a plurality of sub-insulating parts 1054 extending along the first direction D1 and spaced from each other in the second direction D2. The orthographic projections of two adjacent sub-insulating parts 1054 among the plurality of sub-insulating parts 1054 on the base substrate 101 partially overlap with the orthographic projection of an electrode on the base substrate 101, respectively. The electrodes are spaced apart from each other in the second direction D2, the sub-insulating parts 1054 are also spaced apart from each other in the second direction D2, and each electrode corresponds to two sub-insulating parts 1054, so there must be a portion of the space between two adjacent electrodes without sub-insulating parts 1054. As illustrated in a region W in FIG. 9A, the sub-insulating part 1054 is not disposed in this region W. By not arranging the first insulating layer 105 in the region W, the stack thickness of the insulating layer in the region W can be reduced, so that the peeling problem of layers caused by the excessive thickness of the stacked insulating layers can be alleviated.

As illustrated in FIG. 9A, the orthographic projection of the first end P of the electrode formed by a first electrode 1033 and a second electrode 1023 corresponding to the first electrode 1033 on the base substrate 101 partially overlaps with the orthographic projections of the two adjacent sub-insulating parts 1054 on the base substrate 101. Therefore, the two adjacent sub-insulating parts 1054 can protect the first end P of the electrode. When the first insulating layer 105 is etched, even if the etching time is increased, at most, the surface of the first electrode 1033 facing away from the base substrate 101 may be over-etched, but since the thickness of the electrode is greater than the thickness of the second insulating layer 104, the first electrode 1033 can at least partially shield and protect the second electrode 1023, and the first end P of the second electrode 1023 will not be etched substantially. Therefore, the surface of the first end P of the second electrode 1023 is basically not exposed. That is, the first ends P of the second electrodes 1023 of various signal lines are basically not exposed, so that the abnormal growth of nickel-gold basically does not occur.

As illustrated in FIG. 9B, in an example, the overlapping width W3 of the sub-insulating part 1054 of the first insulating layer 105 and the first electrode 1033 along the second direction D2 is about 15µm, so as to protect the two sides of the first electrode 1033 extending along the first direction D1. The overlapping width W4 of the second insulating layer 104 and the second electrode 1023 along the second direction D2 is about 22µm, so as to protect two sides of the second electrode 1023 extending along the first direction D1.

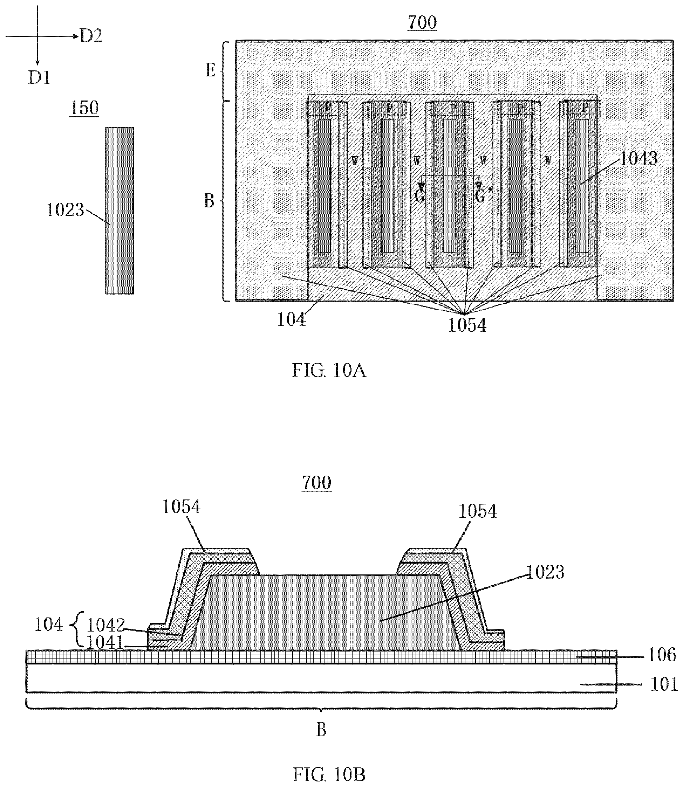

FIG. 10A illustrates a schematic plan view of a partial structure of a wiring substrate 700 in the bonding region B and the functional region E, and FIG. 10B illustrates a cross-sectional view taken along the line GG' in FIG. 10A. For the sake of brevity, the similarities between the wiring substrate 700 and the wiring substrate 100 will not be described, and only the differences between the wiring substrate 700 and the wiring substrate 100 will be described below.

The wiring substrate 700 illustrated in FIG. 10A comprises structures such as a base substrate 101, a first conductive layer 102, a second conductive layer 103, a first insulating layer 105, and a second insulating layer 104. Different from the wiring substrate 100, the first conductive layer 102 of the wiring substrate 700 is arranged in the functional region E and the bonding region B, the first conductive layer 102 comprises a third part 1022 in the bonding region B, the third part 1022 comprises a plurality of second electrodes 1023 extending along the first direction D1, and the exposed region of the second electrode 1023 constitutes the bonding electrode 107. The second electrode 1023 comprises a first end P close to the functional region E. In some embodiments, the second conductive layer 103 of the wiring substrate 700 is only arranged in the functional region E, but not in the bonding region B. In an alternative embodiment, the second conductive layer 103 is neither disposed in the functional region E nor in the bonding region B, that is, the wiring substrate 700 only comprises the first conductive layer 102 and does not comprise the second conductive layer 103. It should be noted that FIG. 10A only illustrates a schematic structural diagram of a partial region of the wiring substrate 700, and the schematic diagram does not illustrate the electrical connection relationship between the third part 1022 and various signal lines in the functional region E. In fact, in the wiring substrate 700, the third part 1022 is electrically connected to various signal lines in the first conductive layer 102, such as the power signal line 103, the address signal line 108, the feedback signal line 110, the common voltage signal line 111 and the driving voltage signal line VLED.

The second insulating layer 104 comprises a plurality of vias 1043, the plurality of vias 1043 correspond to the plurality of second electrodes 1023 one by one, and the orthographic projection of each of the plurality of vias 1043 on the base substrate 101 falls within the orthographic projection of a second electrode 1023 corresponding to the via 1043 on the base substrate 101.

As illustrated in FIG. 10A, the main part 1051 of the first insulating layer 105 comprises a plurality of sub-insulating parts 1054 extending along the first direction D1 and spaced from each other in the second direction D2. The orthographic projections of two adjacent sub-insulating parts 1054 among the plurality of sub-insulating parts 1054 on the base substrate 101 partially overlap with the orthographic projection of one second electrode 1023 on the base substrate 101 respectively, and the orthographic projection of the first end P of the second electrode 1023 on the base substrate 101 partially overlaps with the orthographic projections of the two adjacent sub-insulating parts 1054 on the base substrate 101. The second electrodes 1023 are arranged at intervals from each other in the second direction D2, the sub-insulating parts 1054 are also arranged at intervals from each other in the second direction D2, and each second electrode 1023 corresponds to two sub-insulating parts 1054. Therefore, there must be a portion of the space between two adjacent second electrodes 1023 without the sub-insulating part 1054, as illustrated in the region W in FIG. 10A, where the sub-insulating part 1054 does not exist. By not arranging the first insulating layer 105 in the region W, the stack thickness of the insulating layers in the region W can be reduced, so that the peeling problem caused by the excessive thickness of the stacked insulating layers can be alleviated.

In an example, the overlapping width of the sub-insulating part 1054 of the first insulating layer 105 and the second electrode 1023 along the second direction D2 is about 22µm, so as to protect two sides of the second electrode 1023 extending along the first direction D1. The overlapping width of the second insulating layer 104 and the second electrode 1023 along the second direction D2 is about 15-20µm, so as to protect the two sides of the second electrode 1023 extending along the first direction D1.

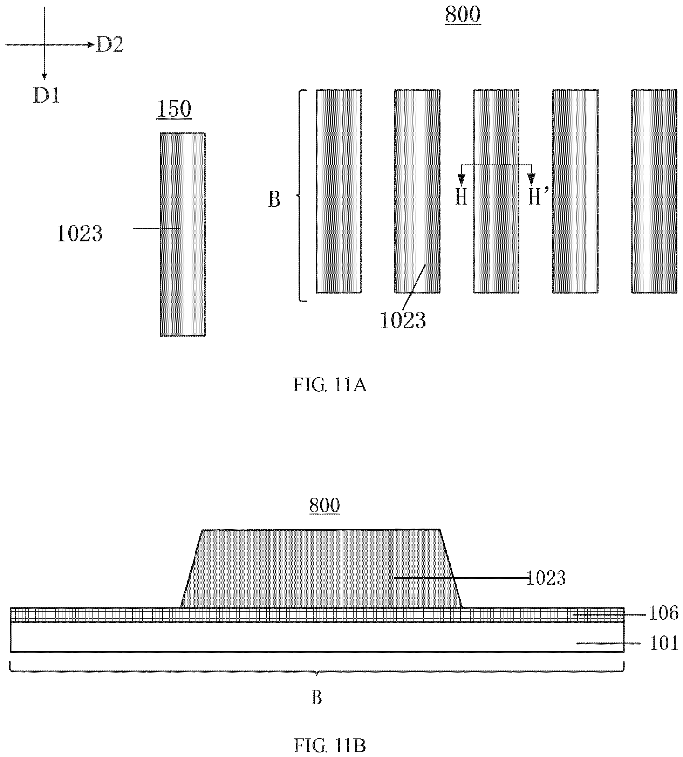

FIG. 11A illustrates a schematic plan view of a wiring substrate 800 in the bonding region B, and FIG. 11B illustrates a cross-sectional view taken along the line HH' of FIG. 11A. For the sake of brevity, the similarities between the wiring substrate 800 and the wiring substrate 100 will not be described, and only the differences between the wiring substrate 800 and the wiring substrate 100 will be described below.

The wiring substrate 800 illustrated in FIG. 11A comprises structures such as a base substrate 101, a first conductive layer 102, a second conductive layer 103, a first insulating layer 105, and a second insulating layer 104. Different from the wiring substrate 100, the first insulating layer 105 and the second insulating layer 104 of the wiring substrate 800 are only arranged in the functional region E, but not in the bonding region B. The first conductive layer 102 is arranged in the functional region E and the bonding region B. The first conductive layer 102 comprises a third part 1022 in the bonding region B, the third part 1022 comprises a plurality of second electrodes 1023 extending along the first direction D1, and the second electrode 1023 constitutes the bonding electrode 107. In some embodiments, the second conductive layer 103 of the wiring substrate 800 is only arranged in the functional region E, but not in the bonding region B. In an alternative embodiment, the second conductive layer 103 is neither disposed in the functional region E nor in the bonding region B, that is, the wiring substrate 800 only comprises the first conductive layer 102 and does not comprise the second conductive layer 103. It should be noted that FIG. 11A only illustrates a schematic structural diagram of a partial region of the wiring substrate 800, and the schematic diagram does not illustrate the electrical connection relationship between the third part 1022 and various signal lines in the functional region E. In fact, in the wiring substrate 800, the third part 1022 is electrically connected to various signal lines in the first conductive layer 102, such as the power signal line 103, the address signal line 108, the feedback signal line 110, the common voltage signal line 111, and the driving voltage signal line VLED.

By etching and removing the portions of the first insulating layer 105 and the second insulating layer 104 which are located in the bonding region B, it is possible to avoid the stack of multiple insulating layers in the bonding region B, so as to prevent the peeling problem of the layers caused by the stack of multiple insulating layers.

It should be noted, for the wiring substrate 200 illustrated in FIGS. 5A-5B, the wiring substrate 300 illustrated in FIGS. 6A-6B, the wiring substrate 400 illustrated in FIGS. 7A-7B, the wiring substrate 500 illustrated in FIGS. 8A-8B, the wiring substrate 600 illustrated in FIGS. 9A-9B, the wiring substrate 700 illustrated in FIGS. 10A-10B, and the wiring substrate 800 illustrated in FIGS. 11A-11B, the first conductive layer 102 of these wiring substrates comprises various types of signal lines in the functional region E, such as power signal lines 103, address signal lines 108, feedback signal lines 110, common voltage signal lines 111 and driving voltage signal lines VLED, etc.. These signal lines generally have different widths along the second direction D2. For example, the width of each of the common voltage signal line 111 and the driving voltage signal line VLED along the second direction D2 is generally greater than the width of any one of the power signal line 103, the address signal line 108, and the feedback signal line 110 along the second direction D2. For signal lines with different widths, the number of second electrodes 1023 comprised in their respective third parts 1022 is different. For example, if the width of a signal line (such as a power signal line 103, an address signal line 108, or a feedback signal line 110) in the functional region E along the second direction D2 is equivalent to the width of the electrode 150 in the bonding region along the second direction D2, then the third part 1022 of the signal line that is in the bonding region B only comprises one second electrode 1023. If the width of a signal line (such as the driving voltage signal line VLED or the common voltage signal line 111) in the functional region E along the second direction D2 is much larger than the width of the electrode 150 in the bonding region along the second direction D2, then the third part 1022 of the signal line that is in the bonding region B comprises a plurality of second electrodes 1023. In some embodiments, the plurality of second electrodes 1023 belonging to the same signal line are connected to each other at the first end.

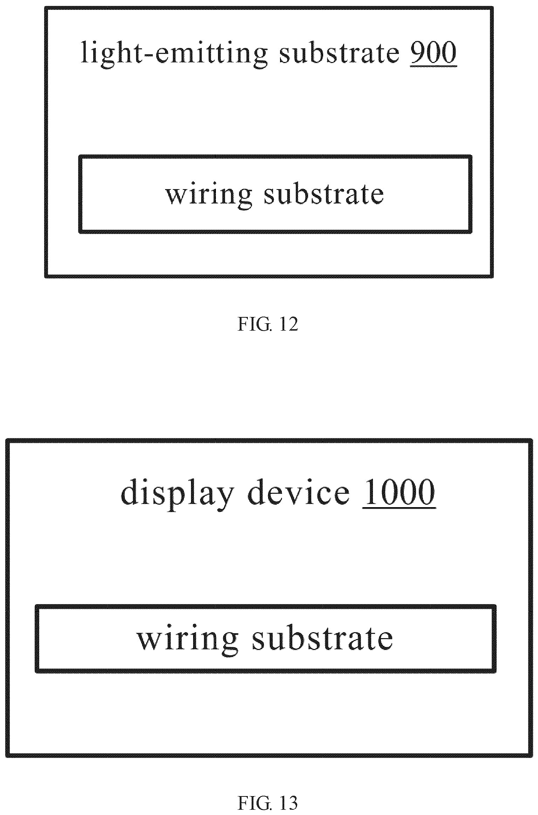

According to another aspect of the present disclosure, a light-emitting substrate is provided. FIG. 12 illustrates a block diagram of a light-emitting substrate 900. The light-emitting substrate 900 comprises the wiring substrate described in any one of the previous embodiments, a plurality of light-emitting elements arranged in the functional region E and a circuit board arranged in the bonding region B. In some embodiments, each light-emitting element may be a light-emitting diode (LED), a submillimeter light-emitting diode (Mini LED) or a micro light-emitting diode (Mirco LED). Using the Mini LED as a light-emitting element can realize a high-dynamic range display. When the light-emitting substrate is applied to a display device, the contrast ratio of the display device can be significantly improved. The circuit board may be, for example, a flexible circuit board (FPC). One end of the FPC is connected to a printed circuit board (PCBA), and the other end of the FPC is connected to the bonding electrodes 107 on the light-emitting substrate 900, for example, through a chip-on-film (COF). The control signal of the IC on the PCBA is transmitted to the bonding electrodes 107 through the FPC. One end of the plurality of signal lines on the light-emitting substrate 900 is bonded to the bonding electrodes 107, and the other end is electrically connected to the light-emitting element. Therefore, the control signal can be transmitted to the light-emitting element through the signal line to control the light-emitting element to emit light.

The light-emitting substrate 900 provided by the embodiment of the present disclosure can basically have the same technical effect as the wiring substrates described in the previous embodiments. Therefore, for the purpose of brevity, the technical effect of the light-emitting substrate 900 will not be described here again.

According to still another aspect of the present disclosure, a display device is provided. FIG. 13 illustrates a block diagram of a display device 1000 comprising the wiring substrate or the light-emitting substrate described in any one of the preceding embodiments. In some embodiments, the display device 1000 may be a liquid crystal display device, which comprises a liquid crystal panel and a backlight arranged on the non-display side of the liquid crystal panel, and the backlight comprises the wiring substrate described in any of the previous embodiments, for example the backlight can be used to implement HDR dimming for display operation. The liquid crystal display device can have more uniform backlight brightness and better display contrast. The display device 1000 can be any suitable display device, comprising but not limited to a mobile phone, a tablet computer, a television, a monitor, a notebook computer, a digital photo frame, a navigator, an e-book, or any other products or components with display function.

Since the display device 1000 can basically have the same technical effect as the wiring substrate described in the previous embodiments, for the sake of brevity, the technical effect of the display device 1000 will not be described here again.

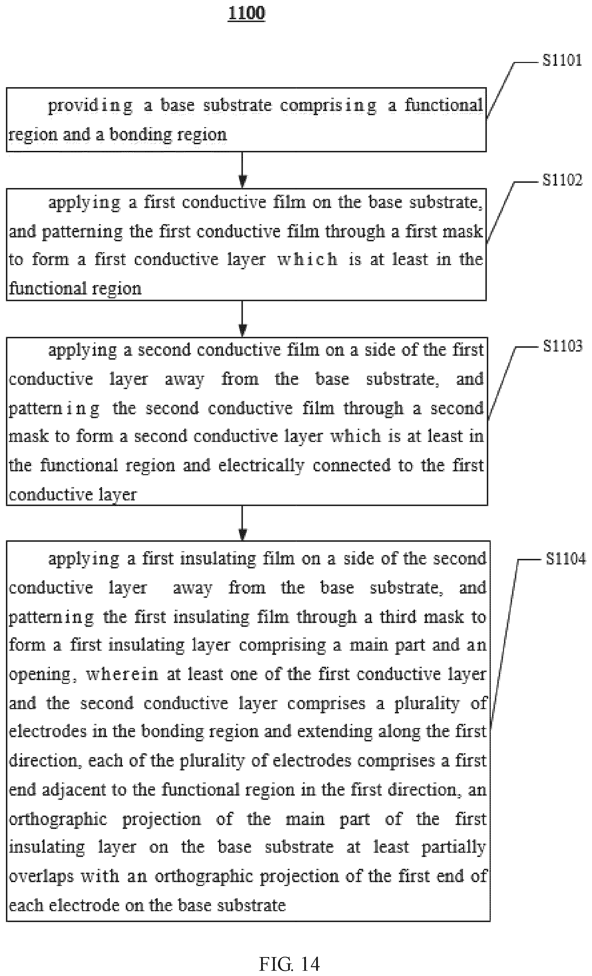

According to yet another aspect of the present disclosure, a method for manufacturing a wiring substrate is provided. FIG. 14 illustrates a flow chart of the method 1100, and the method 1100 can be applied to the wiring substrate described in any of the foregoing embodiments. Method 1100 may comprise the following steps.

S1101: providing a base substrate 101. The base substrate 101 comprises a functional region E and a bonding region B.

The base substrate 101 may be a flexible or rigid material, specifically, may be PEN resin, silicone resin, polyimide, glass, quartz, plastic, etc. The embodiment of the present disclosure does not limit the material of the base substrate 101.

S1102: applying a first conductive film on the base substrate 101, and patterning the first conductive film through a first mask to form a first conductive layer 102. The first conductive layer 102 is at least in the functional region E.

A first conductive film is applied on the base substrate 101 by a magnetron sputtering method or an electroplating method, and is patterned by using a first mask to form a first conductive layer 102. The first conductive layer 102 may comprise the driving voltage signal line, the address signal line, the power signal line, the data driving signal line, the common voltage signal line, the feedback signal line and optional second electrode 1023 as mentioned above. In an example, the first conductive layer 102 may be a stack of MoNb/Cu/MoNb. In an alternative embodiment, the first conductive layer 102 may be a stack of Mo/Cu/Mo.

S1103: applying a second conductive film on the side of the first conductive layer 102 away from the base substrate 101, and patterning the second conductive film through a second mask to form a second conductive layer 103. The second conductive layer 103 is at least in the functional region B and electrically connected to the first conductive layer 102.

A second conductive film is applied on the side of the first conductive layer 102 away from the base substrate 101 by a magnetron sputtering method or an electroplating method, and patterned by using a second mask to form the second conductive layer 103. The second conductive layer 103 may comprise the first pad group 102, the second pad group 104 and the optional first electrode 1033 as mentioned above. The first pad group 102 can be used for installing the micro driver chip 002, and the second pad group 104 can be used for installing the electronic element 003. In an example, the second conductive layer 103 may be formed by the following process: first, a MoNb layer with a thickness of about 300Å is formed on the side of the first conductive layer 102 away from the base substrate 101, then a Cu layer with a thickness of about 6000~9000Å is formed on the MoNb layer, finally, a MoNb layer with a thickness of about 300Å is formed on the Cu layer. In an alternative example, the second conductive layer 103 may be formed by the following process: first, a Mo layer with a thickness of about 300 Å is formed on the side of the first conductive layer 102 away from the base substrate 101, then a Cu layer with a thickness of about 6000~9000Å is formed on the Mo layer, and finally a Mo layer with a thickness of about 17~30Å is formed on the Cu layer.

S1104: applying a first insulating film on the side of the second conductive layer 103 away from the base substrate 101, and patterning the first insulating film through a third mask to form a first insulating layer 105 comprising the main part 1051 and the opening 1052. At least one of the first conductive layer 102 and the second conductive layer 103 comprises a plurality of electrodes in the bonding region B and extending along the first direction D1, each of the plurality of electrodes comprises a first end P adjacent to the functional region E in the first direction D1. The orthographic projection of the main part 1051 of the first insulating layer 105 on the base substrate 101 at least partially overlaps with the orthographic projection of the first end P of each electrode on the base substrate 101.

The first insulating layer 105 may be formed on the side of the second conductive layer 103 away from the base substrate 101 by a magnetron sputtering method. By making the orthographic projection of the main part 1051 of the first insulating layer 105 on the base substrate 101 at least partially overlap with the orthographic projection of the first end P of each electrode on the base substrate 101, it is possible to prevent the abnormal growth of nickel-gold at the first end P of the signal line. The material of the first insulating layer 105 may be organic material, inorganic material or a combination of organic material and inorganic material. The first insulating layer 105 may be a single layer, or may comprise multiple layers.

In some embodiments, after forming the first conductive layer 102 and before forming the second conductive layer 103, it may further comprise: applying a second insulating film on the side of the first conductive layer 102 away from the base substrate 101 by a magnetron sputtering method, and patterning the second insulating film through a fourth mask to form the second insulating layer 104. The material of the second insulating layer 104 may be organic material, inorganic material or a combination of organic material and inorganic material. The second insulating layer 104 may be a single layer, or may comprise multiple layers. In an example, the second insulating layer 104 comprises a first sub-insulating layer 1041 and a second sub-insulating layer 1042.

In an embodiment where the second insulating layer 104 comprises a first sub-insulating layer 1041 and a second sub-insulating layer 1042, an OC (Over Coating) layer may also be formed between the first sub-insulating layer 1041 and the second sub-insulating layer 1042 through a fifth mask, and the OC layer may be a negative photoresist made of organic material. The thickness of the OC layer is greater than that of the first insulating layer 105 and the second insulating layer 104, and the OC layer is usually arranged only in the functional region E. In an example, the thickness of the OC layer is 3~4 microns. The thicker OC layer can be used to wrap the particles between the first conductive layer 102 and the second conductive layer 103 to prevent the particles from piercing the first conductive layer 102 and the second conductive layer 103, so as to avoid a short circuit between them. In addition, the OC layer can play a role of planarization.

In some embodiments, before forming the first conductive layer 102, the method may further comprise: forming a buffer layer 106 on the base substrate 101, for example, by a magnetron sputtering method. The buffer layer 106 can be used to reduce the stress on the base substrate 101 during the subsequent preparation of the first conductive layer 102 and the second conductive layer 103, so as to avoid bending deformation of the base substrate 101. The buffer layer 106 may also prevent impurities in the base substrate 101 from adversely affecting the conductivity of the subsequently formed first conductive layer 102 and second conductive layer 103. The buffer layer 112 can be any suitable material, for example, SiN, SiO or SiON.

The method 1100 can use fewer masks (for example, five masks) to prepare a wiring substrate. Compared with the related art that requires at least seven masks to prepare the wiring substrate, the method 1100 provided by the embodiment of the present disclosure can reduce the number of required masks, simplify the process and reduce the production cost. For other technical effects achieved by the method 1100, reference may be made to the technical effects of the wiring substrate described in the foregoing embodiments, for the purpose of brevity, no repeated description is given here.

It will be understood that although the terms first, second, third, etc. may be used herein to describe various elements, components, regions, layers and/or portions, these elements, components, regions, layers and/or portions should not be limited by these terms. These terms are only used to distinguish an element, component, region, layer or portion from another element, component, region, layer or portion. Thus, a first element, component, region, layer or portion discussed above could be termed a second element, component, region, layer or portion without departing from the teachings of the present disclosure.

Spatially relative terms such as "row", "column", "below", "above", "left", "right", etc. may be used herein for ease of description to describe factors such as the relationship of an element or feature to another element(s) or feature(s) illustrated in the figures. It will be understood that these spatially relative terms are intended to encompass different orientations of the device in use or operation in addition to the orientation depicted in the figures. For example, if the device in the figures is turned over, elements described as "below" other elements or features would then be oriented "above" other elements or features. Thus, the exemplary term "below" can encompass both an orientation of above and below. The device may be otherwise oriented (rotated 90 degrees or at other orientations) and the spatially relative descriptors used herein are interpreted accordingly. In addition, it will also be understood that when a layer is referred to as being "between" two layers, it can be the only layer between the two layers, or one or more intervening layers may also be present.

The terminology used herein is for the purpose of describing particular embodiments only and is not intended to limit the present disclosure. As used herein, the singular forms "a," "an," and "the" are intended to comprise the plural forms as well, unless the context clearly dictates otherwise. It will be further understood that the terms "comprise" and/or "include" when used in this specification designate the presence of stated features, integers, steps, operations, elements and/or parts, but do not exclude the presence or addition of one or more other features, integers, steps, operations, elements, components and/or groups thereof. As used herein, the term "and/or" comprises any and all combinations of one or more of the associated listed items. In the description of this specification, description with reference to the terms "an embodiment," "another embodiment," etc. means that a particular feature, structure, material, or characteristic described in connection with the embodiment is included in at least one embodiment of the present disclosure. In this specification, schematic representations of the above terms are not necessarily directed to the same embodiment or example. Furthermore, the particular features, structures, materials or characteristics described may be combined in any suitable manner in any one or more embodiments or examples. Furthermore, those skilled in the art may combine the different embodiments or examples as well as the features of the different embodiments or examples described in this specification without conflicting each other.

It will be understood that when an element or layer is referred to as being "on", "connected to", "coupled to", or "adjacent to" another element or layer, it may be directly on, directly connected to, directly coupled to, or directly adjacent to another element or layer, or intervening elements or layers may be present. In contrast, when an element is referred to as being "directly on", "directly connected to", "directly coupled to", "directly adjacent to" another element or layer, with no intervening elements or layers present. However, in no case should "on" or "directly on" be interpreted as requiring a layer to completely cover the layer below.

Embodiments of the disclosure are described herein with reference to schematic illustrations (and intermediate structures) of idealized embodiments of the disclosure. As such, variations to the shapes of the illustrations are to be expected, e.g., as a result of manufacturing techniques and/or tolerances. Accordingly, embodiments of the present disclosure should not be construed as limited to the particular shapes of the regions illustrated herein, but are to comprise deviations in shapes due, for example, to manufacturing. Thus, the regions illustrated in the figures are schematic in nature and their shapes are not intended to illustrate the actual shape of a region of a device and are not intended to limit the scope of the present disclosure.

Unless otherwise defined, all terms (comprising technical and scientific terms) used herein have the same meaning as commonly understood by one of ordinary skill in the art to which this disclosure belongs. It will be further understood that terms such as those defined in commonly used dictionaries should be construed to have meanings consistent with their meanings in the relevant art and/or the context of this specification, and will not be idealized or overly interpreted in a formal sense, unless expressly defined as such herein.

The above descriptions are merely specific embodiments of the present disclosure, but the protection scope of the present disclosure is not limited thereto. Any changes or substitutions that those skilled in the art can easily think of within the technical scope disclosed by the present disclosure, should be comprised within the protection scope of the present disclosure. Therefore, the protection scope of the present disclosure should be based on the protection scope of the claims.

## Claims

1. A wiring substrate comprising:
a base substrate comprising a functional region and a bonding region;
a first conductive layer on the base substrate and at least in the functional region;
a second conductive layer on a side of the first conductive layer away from the base substrate and at least in the functional region, the second conductive layer being electrically connected to the first conductive layer; and
a first insulating layer on a side of the second conductive layer away from the base substrate and comprising a main part and an opening,
wherein at least one of the first conductive layer and the second conductive layer comprises a plurality of electrodes in the bonding region and extending along a first direction, each of the plurality of electrodes comprises a first end adjacent to the functional region in the first direction, and an orthographic projection of the main part of the first insulating layer on the base substrate at least partially overlaps with an orthographic projection of the first end of each electrode on the base substrate.

2. The wiring substrate according to claim 1, further comprising a second insulating layer between the first conductive layer and the second conductive layer, wherein the second conductive layer is in contact with the first conductive layer through a via in the second insulating layer.

3. The wiring substrate according to claim 2, wherein the second conductive layer comprises a first part and a second part, the first part is in the functional region, the second part is in the bonding region, the second part comprises a plurality of first electrodes extending along the first direction, and each of the plurality of first electrodes comprises the first end.

4. The wiring substrate according to claim 3, wherein the second conductive layer comprises a first surface facing away from the base substrate, a distance between a portion of the first surface at the first part and the base substrate is greater than a distance between a portion of the first surface at the second part and the base substrate, and an orthographic projection of the opening of the first insulating layer on the base substrate at least partially overlaps with an orthographic projection of the second part on the base substrate.

5. The wiring substrate according to claim 4, wherein the opening of the first insulating layer exposes a remaining portion of each first electrode except the first end.

6. The wiring substrate according to claim 5, wherein in the bonding region, the orthographic projection of the opening of the first insulating layer on the base substrate does not overlap with an orthographic projection of the second insulating layer on the base substrate.

7. The wiring substrate according to any one of claims 3-6, wherein the first conductive layer is only in the functional region, and an orthographic projection of the first conductive layer on the base substrate partially overlaps with an orthographic projection of the first part of the second conductive layer on the base substrate.

8. The wiring substrate according to claim 7, wherein in the functional region, the first conductive layer comprises a second surface facing the second conductive layer and a side surface contiguous with the second surface and facing the bonding region, the second conductive layer is in direct contact with the side surface of the first conductive layer.

9. The wiring substrate according to claim 3,
wherein the first conductive layer comprises a third part in the bonding region, the third part comprises a plurality of second electrodes extending along the first direction, the plurality of first electrodes correspond to the plurality of second electrodes one by one, and an orthographic projection of each of the plurality of first electrodes on the base substrate at least partially overlaps with an orthographic projection of a corresponding one of the plurality of second electrodes on the base substrate, and
wherein each first electrode is electrically connected to a second electrode corresponding to the first electrode, the first electrode and the second electrode which are electrically connected constitute the electrode, and both the first electrode and the second electrode which are electrically connected comprise the first end.

10. The wiring substrate according to claim 9, wherein orthographic projections of the first ends of the first electrode and the second electrode on the base substrate fall within the orthographic projection of the main part of the first insulating layer on the base substrate.

11. The wiring substrate according to claim 10, wherein the opening of the first insulating layer exposes a remaining portion of each first electrode except the first end.

12. The wiring substrate according to claim 10, wherein each second electrode comprises a plurality of tooth-like structures extending along the first direction and arranged along a second direction, the second direction intersects with the first direction.

13. The wiring substrate according to claim 12, wherein each of the plurality of tooth-like structures comprises a second surface facing the second conductive layer and a side surface contiguous with the second surface, the first electrode is in direct contact with the side surface of the tooth-like structure.

14. The wiring substrate according to claim 12 or 13,
wherein in the bonding region, the first insulating layer comprises a plurality of openings, the plurality of openings correspond to the plurality of electrodes one by one, and an orthographic projection of each of the plurality of openings on the base substrate falls within an orthographic projection of a first electrode corresponding to the opening on the base substrate, and
wherein the electrode further comprises a second end opposite to the first end, and an orthographic projection of the second end of the electrode on the base substrate falls within the orthographic projection of the main part of the first insulating layer on the base substrate.

15. The wiring substrate according to claim 12 or 13,
wherein in the bonding region, the first insulating layer comprises a plurality of openings, the plurality of openings correspond to the plurality of electrodes one by one, and an orthographic projection of each of the plurality of openings on the base substrate partially overlaps with an orthographic projection of an electrode corresponding to the opening on the base substrate, and
wherein the electrode further comprises a second end opposite to the first end, a portion of the second end is exposed by an opening corresponding to the electrode.

16. The wiring substrate according to claim 10, wherein an orthographic projection of the second insulating layer on the base substrate does not overlap with orthographic projections of the first electrode and the second electrode on the base substrate, and the first electrode of each electrode is in direct contact with the second electrode of each electrode.

17. The wiring substrate according to claim 16,
wherein in the bonding region, the first insulating layer comprises a plurality of openings, the plurality of openings correspond to the plurality of electrodes one by one, and an orthographic projection of each of the plurality of openings on the base substrate falls within an orthographic projection of the first electrode of the electrode corresponding to the opening on the base substrate, and
wherein the electrode further comprises a second end opposite to the first end, and an orthographic projection of the second end of the electrode on the base substrate falls within the orthographic projection of the main part of the first insulating layer on the base substrate.

18. The wiring substrate according to claim 9, wherein for each electrode, the orthographic projection of the first electrode on the base substrate falls within the orthographic projection of the second electrode on the base substrate.

19. The wiring substrate according to claim 18, wherein the main part of the first insulating layer comprises a plurality of sub-insulating parts extending in the first direction and spaced apart from each other in a second direction intersecting the first direction, orthographic projections of two adjacent sub-insulating parts of the plurality of sub-insulating parts on the base substrate partially overlap with an orthographic projection of an electrode on the base substrate, respectively, and orthographic projections of the first ends of the first electrode and the second electrode on the base substrate partially overlap with the orthographic projections of the two adjacent sub-insulating parts on the base substrate.

20. The wiring substrate according to claim 2, wherein the second conductive layer is arranged only in the functional region, the first conductive layer comprises a third part arranged in the bonding region, the third part comprises a plurality of second electrodes extending along the first direction, and each of the plurality of second electrodes comprises the first end.

21. The wiring substrate according to claim 20, wherein the second insulating layer comprises a plurality of vias, the plurality of vias correspond to the plurality of second electrodes one by one, and an orthographic projection of each of the plurality of vias on the base substrate falls within an orthographic projection of a second electrode corresponding to the via on the base substrate.

22. The wiring substrate according to claim 21, wherein the main part of the first insulating layer comprises a plurality of sub-insulating parts extending in the first direction and spaced apart from each other in a second direction intersecting the first direction, orthographic projections of two adjacent sub-insulating parts of the plurality of sub-insulating parts on the base substrate partially overlap with an orthographic projection of a second electrode on the base substrate, respectively, and an orthographic projection of the first end of the second electrode on the base substrate partially overlaps with the orthographic projections of the two adjacent sub-insulating parts on the base substrate.

23. A light-emitting substrate comprising the wiring substrate according to any one of claims 1-22, a plurality of light-emitting elements arranged in the functional region, and a circuit board arranged in the bonding region.

24. A display device comprising the wiring substrate according to any one of claims 1-22 or the light-emitting substrate according to claim 23.

25. A method of manufacturing a wiring substrate comprising:
providing a base substrate comprising a functional region and a bonding region;
applying a first conductive film on the base substrate, patterning the first conductive film through a first mask to form a first conductive layer which is at least in the functional region;
applying a second conductive film on a side of the first conductive layer away from the base substrate, patterning the second conductive film through a second mask to form a second conductive layer which is at least in the functional region and electrically connected to the first conductive layer; and
applying a first insulating film on a side of the second conductive layer away from the base substrate, patterning the first insulating film through a third mask to form a first insulating layer comprising a main part and an opening,
wherein at least one of the first conductive layer and the second conductive layer comprises a plurality of electrodes in the bonding region and extending along a first direction, each of the plurality of electrodes comprises a first end adjacent to the functional region in the first direction, and an orthographic projection of the main part of the first insulating layer on the base substrate at least partially overlaps with an orthographic projection of the first end of each electrode on the base substrate.

26. The method according to claim 25, after the forming a first conductive layer on the base substrate, further comprising:
applying a second insulating film on a side of the first conductive layer away from the base substrate, patterning the second insulating film through a fourth mask to form a second insulating layer; and
forming the second conductive layer on a side of the second insulating layer away from the base substrate.
